# EUROPEAN PATENT APPLICATION

(11) **EP 2 944 757 A1**
(43) Date of publication of application: **18.11.2015**
(21) Application number: 15167833.1
(22) Date of filing: 15.05.2015
(51) Int. Cl.: E21B 43/30, E21B 44/00

(54) **INTERACTIVE WELL PAD PLAN**

(30) Priority: 16.05.2014 US 201461994594 P
(71) Applicant: Services Petroliers Schlumberger, 75007 Paris (FR); Logined B.V., 2586 BJ S Gravenhage (NL)
(72) Inventor: Scollard, Aaron, Houston, TX Texas 77057 (US); Lu, Zhengang, Katy, TX Texas 77450 (US)
(74) Representative: Li, Boxi

(57) **Abstract**

A method can include rendering at least a portion of a plan to a display of a computing system where the plan includes at least one pad that includes associated wells; receiving input that generates an edited plan; and responsive to receiving the input, calculating a production metric for at least a portion of the edited plan and rendering at least a portion of the edited plan and a representation of the production metric to the display.

## Description

### RELATED APPLICATIONS

This application claims priority to and the benefit of a US Provisional Application having Serial No. 61/994,594, filed 16 May 2014, which is incorporated by reference herein. This application is related to the US application with serial no. 13/596,540 filed 28 August 2012 and that claims priority and benefit of US provisional application with serial no. 61/534,926 filed 15 September 2011.

### BACKGROUND

Various industries rely on underground or subsurface placement of piping and other equipment. For example, in the oil and gas industry, a rig or pad to place equipment underground may be located on a ground surface proximate to a reservoir. As to offshore rigs or pads, these may be floating structures or structures with supports that extend to a seabed (a ground surface) to place equipment below a sea surface (a water surface) and below a seabed. Placement of such equipment can depend on any of a variety of factors. Various technologies and techniques described herein pertain to equipment placement.

### SUMMARY

A method can include rendering at least a portion of a plan to a display of a computing system where the plan includes at least one pad that includes associated wells; receiving input that generates an edited plan; and responsive to receiving the input, calculating a production metric for at least a portion of the edited plan and rendering at least a portion of the edited plan and a representation of the production metric to the display. A device can include a processor; memory operatively coupled to the processor; one or more modules that include processor-executable instructions to instruct the device to render at least a portion of a plan to a display where the plan includes at least one pad that includes associated wells; receive input that generates an edited plan; and, responsive to the input, calculate a production metric for at least a portion of the edited plan and render at least a portion of the edited plan and a representation of the production metric to the display. One or more computer-readable storage media can include processor-executable instructions to instruct a computing system to: render at least a portion of a plan to a display where the plan includes at least one pad that includes associated wells; receive input that generates an edited plan; and, responsive to the input, calculate a production metric for at least a portion of the edited plan and render at least a portion of the edited plan and a representation of the production metric to the display. Various other apparatuses, systems, methods, etc., are also disclosed.

This summary is provided to introduce a selection of concepts that are further described below in the detailed description. This summary is not intended to identify key or essential features of the claimed subject matter, nor is it intended to be used as an aid in limiting the scope of the claimed subject matter.

### BRIEF DESCRIPTION OF THE DRAWINGS

Features and advantages of the described implementations can be more readily understood by reference to the following description taken in conjunction with the accompanying drawings.
Fig. 1 illustrates an example system that includes various components for simulating and optionally interacting with a geological environment;
Fig. 2 illustrates an example of an environment that includes various equipment and various features, which may be represented at one or more levels;
Fig. 3 illustrates an example of method for generating pad locations;
Fig. 4 illustrates an example of a method for providing placement options for one or more pads;
Fig. 5 illustrates examples of graphical user interfaces for interacting with a pad placement process;
Fig. 6 illustrates examples of modules and graphical user interfaces for pad placement and design;
Fig. 7 illustrates an example of a graphical user interface;
Fig. 8 illustrates an example of a graphical user interface;
Fig. 9 illustrates example modules and an example of a graphical user interface that includes a pad placement option implemented as a plug-in with respect to a framework;
Fig. 10 illustrates an example of a graphical user interface for selecting geometric restrictions as inputs for a pad placement process;
Fig. 11 illustrates an example of a graphical user interface for geometric modeling of one or more restrictions using a three-dimensional grid;
Fig. 12 illustrates an example of a graphical user interface for a cost functions associated with a geometric restriction;
Fig. 13 illustrates an example of a graphical user interface for selecting pad and well specifications as inputs for a pad placement process;
Fig. 14 illustrates an example of a graphical user interface for selecting placement options for a pad placement process;
Fig. 15 illustrates an example of a scenario to perform sensitivity analysis, optimization or other processes;
Fig. 16 illustrates an examples of graphical user interfaces for rendering information associated with pad placement and restrictions;
Fig. 17 illustrates examples of graphical user interfaces;
Fig. 18 illustrates examples of graphical user interfaces;
Fig. 19 illustrates an example of a graphical user interface;
Fig. 20 illustrates examples of some well configurations;
Fig. 21 illustrates an example of a graphical user interface;
Fig. 22 illustrates an example of a graphical user interface;
Fig. 23 illustrates an example of a graphical user interface;
Fig. 24 illustrates an example of a method;
Fig. 25 illustrates an example of a method;
Fig. 26 illustrates an example of a portion of a plan and examples of computing equipment;
Fig. 27 illustrates an example of a computing device;
Fig. 28 illustrates an example of an environment and an example of a method;
Fig. 29 illustrates an example of a method; and
Fig. 30 illustrates example components of a system and a networked system.

### DETAILED DESCRIPTION

The following description includes the best mode presently contemplated for practicing the described implementations. This description is not to be taken in a limiting sense, but rather is made merely for the purpose of describing the general principles of the implementations. The scope of the described implementations should be ascertained with reference to the issued claims.

As mentioned, various industries rely on underground or subsurface placement of piping and other equipment and placement of such equipment can depend on any of a variety of factors. For example, an underground rock formation or existing underground equipment may be considered obstacles to avoid or that introduce costs (e.g., drilling through the rock, removing or relocating existing equipment, etc.). Other factors can include property rights such as leasehold boundaries, public infrastructure (e.g., roads, power lines, communication lines, etc.), and even moving obstacles such as ice formations (e.g., icebergs).

A pad may be a formation or structure to be located or placed for purposes of performing one or more types of underground or subsurface operations. For example, in the oil and gas industry a ground surface pad may be a temporary drilling site constructed of materials such as gravel, shell or wood. Such materials may be local materials (e.g., sourced locally for reasons of cost, environmental impact, etc.). For some long-drilling-duration operations, deep wells, such as the ultradeep wells of western Oklahoma, or some regulatory jurisdictions such as The Netherlands, a pad may be constrained, for example, as having to be paved with asphalt or concrete. For temporary pads, after a drilling operation is over, most of a pad may optionally be removed, plowed back into the ground, etc.

A rig may be a machine used to drill a bore such as a wellbore. In onshore operations, a rig may include various types of support equipment. Major components of a rig can include mud tanks, mud pumps, a derrick or mast, drawworks, a rotary table or topdrive, a drillstring, power generation equipment and auxiliary equipment. Offshore, a rig can include various components, for example, as for an onshore rig. For offshore operations, a pad may be a vessel or drilling platform itself while the rig may be referred to as a drilling package.

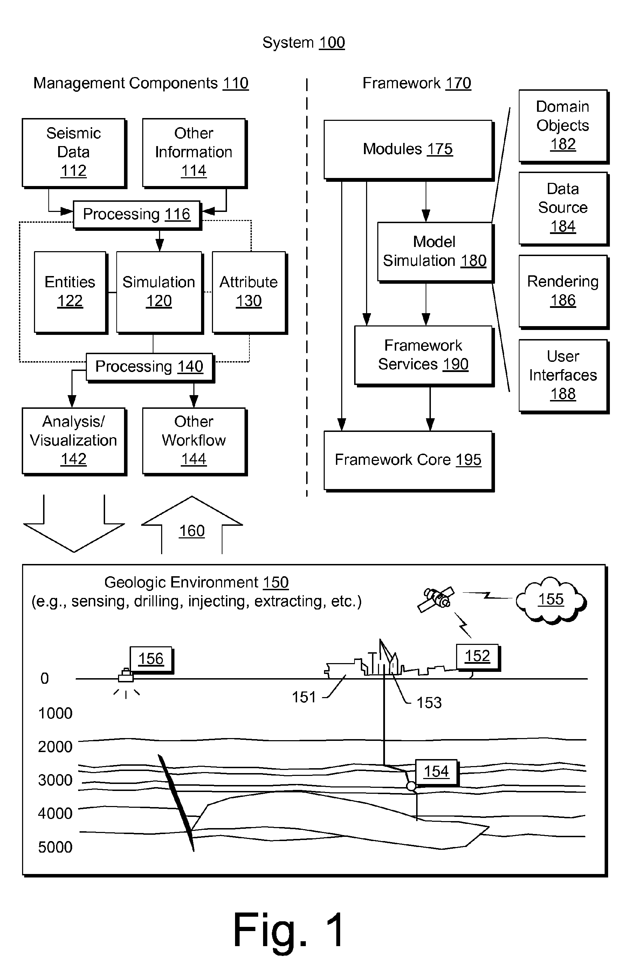

To facilitate explanation of various examples of pad or rig placement processes and related processes, Fig. 1 shows an example of a system 100 that includes various management components 110 to manage various aspects of a geologic environment 150. For example, the management components 110 may allow for direct or indirect management of sensing, drilling, injecting, extracting, etc., with respect to the geologic environment 150. In turn, further information about the geologic environment 150 may become available as feedback 160 (e.g., optionally as input to one or more of the management components 110).

In the example of Fig. 1, the geologic environment 150 may include a vessel 151 as a pad equipped with a rig 153. The environment 150 may be outfitted with any of a variety of sensors, detectors, actuators, etc. For example, equipment 152 may include communication circuitry to receive and to transmit information with respect to one or more networks 155. Such information may include information associated with downhole equipment 154, which may be equipment to acquire information, to assist with resource recovery, etc. Other equipment 156 may be located remote from a well site and include sensing, detecting, emitting or other circuitry. Such equipment may include storage and communication circuitry to store and to communicate data, instructions, etc.

As to the management components 110 of Fig. 1, these may include a seismic data component 112, an information component 114, a pre-simulation processing component 116, a simulation component 120, an attribute component 130, a post-simulation processing component 140, an analysis/visualization component 142 and a workflow component 144. In operation, seismic data and other information provided per the components 112 and 114 may be input to the simulation component 120, optionally with pre-simulation processing via the processing component 116 and optionally with post-simulation processing via the processing component 140.

As an example, the simulation component 120 may include entities 122. Entities 122 may be earth entities or geological objects such as wells, surfaces, reservoirs, etc. In the system 100, the entities 122 can include entities that provide for virtual representations of actual physical entities, for example, that are reconstructed for purposes of simulation. The entities 122 may be based on data acquired via sensing, observation, etc. (e.g., the seismic data 112 and other information 114).

As an example, the simulation component 120 may include a software framework such as an object-based framework. In such a framework, entities may be based on pre-defined classes to facilitate modeling and simulation. A commercially available example of an object-based framework is the MICROSOFT® .NET™ framework (Redmond, Washington), which provides a set of extensible object classes. In the .NET™ framework, an object class encapsulates a module of reusable code and associated data structures. Object classes can be used to instantiate object instances for use in by a program, script, etc. For example, borehole classes may define objects for representing boreholes based on well data.

In the example of Fig. 1, the simulation component 120 may process information to conform to one or more attributes specified by the attribute component 130, which may be a library of attributes. Such processing may occur prior to input to the simulation component 120. Alternatively, or in addition to, the simulation component 120 may perform operations on input information based on one or more attributes specified by the attribute component 130. As an example, the simulation component 120 may construct one or more models of the geologic environment 150, which may be used for simulation of behavior of the geologic environment 150 (e.g., responsive to one or more acts, whether natural or artificial). In the example of Fig. 1, the analysis/visualization component 142 may allow for interaction with a model or model-based results. Additionally, or alternatively, output from the simulation component 120 may be input to one or more other workflows, as indicated by a workflow component 144. A workflow may include worksteps, for example, where each workstep acts upon input to provide an output (e.g., input may be data and output may be a visualization of the data, an analysis of the data, etc.). In the example of Fig. 1, dotted lines indicate possible feedback within the management components 110. For example, feedback may occur between the analysis/visualization component 142 and either one of the processing components 116 and 140.

As an example, the management components 110 may include features of a commercially available simulation framework such as the PETREL® seismic to simulation software framework (Schlumberger Limited, Houston, Texas). The PETREL® framework provides components that allow for optimization of exploration and development operations. The PETREL® framework includes seismic to simulation software components that can output information for use in increasing reservoir performance, for example, by improving asset team productivity. Through use of such a framework, various professionals (e.g., geophysicists, geologists, and reservoir engineers) can develop collaborative workflows and integrate operations to streamline processes. Such a framework may be considered an application and may be considered a data-driven application (e.g., where data is input for purposes of simulating a geologic environment).

As an example, the management components 110 may include features for geology and geological modeling to generate high-resolution geological models of reservoir structure and stratigraphy (e.g., classification and estimation, facies modeling, well correlation, surface imaging, structural and fault analysis, well path design, data analysis, fracture modeling, workflow editing, uncertainty and optimization modeling, petrophysical modeling, etc.). Particular features may allow for performance of rapid 2D and 3D seismic interpretation, optionally for integration with geological and engineering tools (e.g., classification and estimation, well path design, seismic interpretation, seismic attribute analysis, seismic sampling, seismic volume rendering, geobody extraction, domain conversion, etc.). As to reservoir engineering, for a generated model, one or more features may allow for simulation workflow to perform streamline simulation, reduce uncertainty and assist in future well planning (e.g., uncertainty analysis and optimization workflow, well path design, advanced gridding and upscaling, history match analysis, etc.). The management components 110 may include features for drilling workflows including well path design, drilling visualization, and real-time model updates (e.g., via real-time data links).

As an example, various aspects of the management components 110 may be add-ons or plug-ins that operate according to specifications of a framework environment. For example, a commercially available framework environment marketed as the OCEAN® framework environment (Schlumberger Limited, Houston, Texas) allows for seamless integration of add-ons (or plug-ins) into a PETREL® framework workflow. The OCEAN® framework environment leverages .NET® tools (Microsoft Corporation, Redmond, Washington) and offers interfaces for development. As an example, various components may be implemented as add-ons (or plug-ins) that conform to and operate according to specifications of a framework environment (e.g., according to application programming interface (API) specifications, etc.).

Fig. 1 also shows an example of a framework 170 that includes a model simulation layer 180 along with a framework services layer 190, a framework core layer 195 and a modules layer 175. The framework 170 may be the commercially available OCEAN® framework where the model simulation layer 180 is the commercially available PETREL® model-centric software package that hosts OCEAN® framework applications.

In the example of Fig. 1, the model simulation layer 180 may provide domain objects 182, act as a data source 184, provide for rendering 186 and provide for various user interfaces 188. Rendering 186 may provide a graphical environment in which applications can display their data while the user interfaces 188 may provide a common look and feel for application user interface components.

In the example of Fig. 1, the domain objects 182 can include entity objects, property objects and optionally other objects. Entity objects may be used to geometrically represent wells, surfaces, reservoirs, etc., while property objects may be used to provide property values as well as data versions and display parameters. For example, an entity object may represent a well where a property object provides log information as well as version information and display information (e.g., to display the well as part of a model).

In the example of Fig. 1, data may be stored in one or more data sources (or data stores, generally physical data storage devices), which may be at the same or different physical sites and accessible via one or more networks. The model simulation layer 180 may be configured to model projects. As such, a particular project may be stored where stored project information may include inputs, models, results and cases. Thus, upon completion of a modeling session, a user may store a project. At a later time, the project can be accessed and restored using the model simulation layer 180, for example, which may recreate instances of the relevant domain objects.

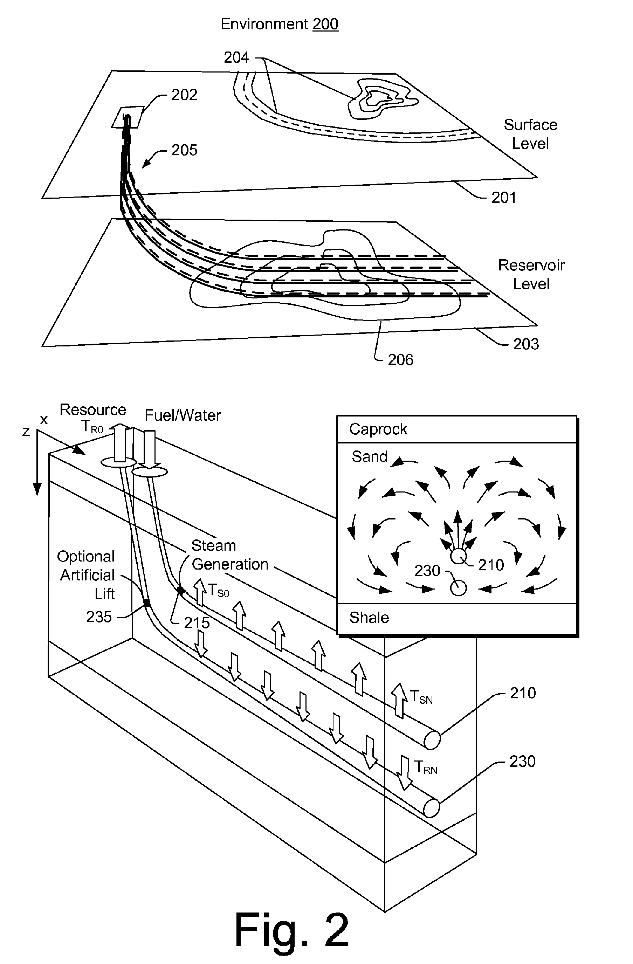

Fig. 2 shows an example of an environment 200 that may be modeled using a multilayer model. For example, such a model may include a surface level 201 (e.g., upper surface or layer) and a reservoir level 203 (e.g., lower surface or layer). As shown in Fig. 2, a structure 202 may be placed (e.g., built) on the surface level 201 for drilling or operating subsurface equipment 205 for exploring, injecting, extracting, etc. Further, placement of the structure 202 may aim to account for various constraints such as roads, soil conditions, etc. As shown, the structure 202 may be, for example, a pad for a rig or rigs (e.g., to drill, to place equipment, to operate equipment, etc.).

In the example of Fig. 2, the equipment 205 may be steam assisted gravity drainage (SAGD) equipment for injecting steam and extracting resources from a reservoir 206. For example, a SAGD operation can include a steam-injection well 210 and a resource production well 230. In the example of Fig. 2, a downhole steam generator 215 generates steam in the injection well 210, for example, based on supplies of water and fuel from surface conduits, and optional artificial lift equipment 235 (e.g., ESP, etc.) may be implemented to facilitate resource production. While a downhole steam generator is shown, steam may be alternatively, or additionally, generated at the surface level. As illustrated in a cross-sectional view, the steam rises in the subterranean portion. As the steam rises, it transfers heat to a desirable resource such as heavy oil. As the resource is heated, its viscosity decreases, allowing it to flow more readily to the resource production well 230.

As to pad placement in such an environment for a SAGD enhanced oil recovery (EOR) operation, various factors may be relevant. For example, area swept by a SAGD set, spacing between wells, etc. As an example, a model can optionally account for such factors when determining one or more possible pad placement locations (or rig placement locations). As an example, where a pad or pads are mentioned, specifications, configurations, etc., for other locatable equipment may be substituted for a pad or pads. As an example, specifications, configurations, etc., may be provided for various types of locatable equipment (e.g., structures or other equipment) and placement locations for such equipment ascertained (e.g., consider ascertaining practical or optimal locations).

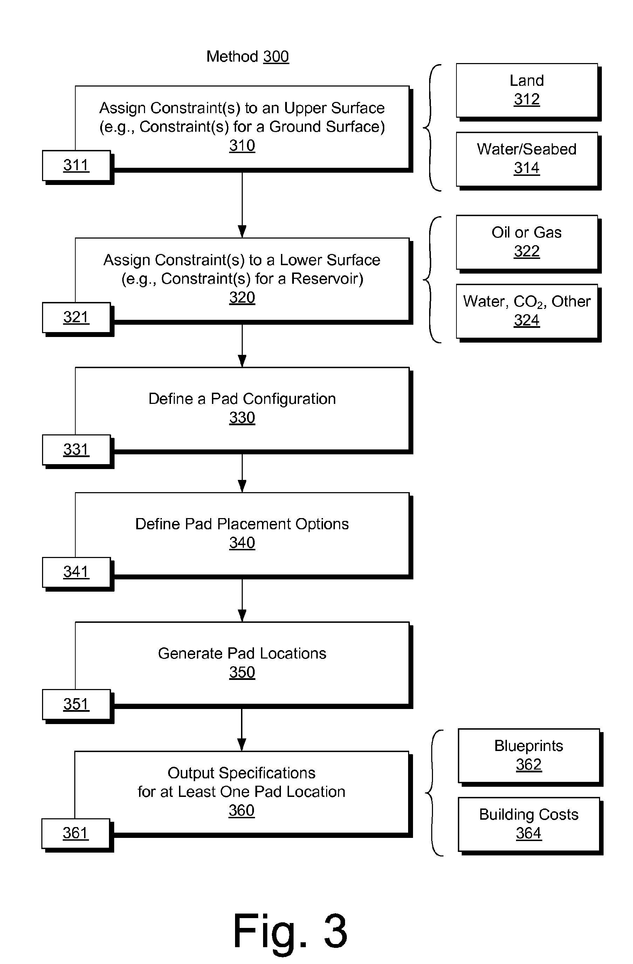

Fig. 3 shows an example of method 300 for generating pad locations. The method 300 includes an assignment block 310 to assign one or more constraints to an upper surface (e.g., a land surface 312 or a water or seabed surface 314), an assignment block 320 to assign one or more constraints to a lower surface (e.g., associated with an oil or gas reservoir 322 or water, CO₂ or other reservoir 324), a definition block 330 to define a pad configuration, a definition block 340 to define pad placement options, a generation block 350 to generate pad locations and an output block 360 to output specifications for at least one pad location (e.g., as blueprints 362, building costs 364, etc.).

The method 300 is shown in Fig. 3 in association with various computer-readable media (CRM) blocks 311, 321, 331, 341, 351 and 361. Such blocks generally include instructions suitable for execution by one or more processors (or cores) to instruct a computing device or system to perform one or more actions. While various blocks are shown, a single medium may be configured with instructions to allow for, at least in part, performance of various actions of the method 300. As an example, a computer-readable medium (CRM) may be a computer-readable storage medium. One or more CRM block may be provided for graphical user interfaces (GUIs), etc.

As an example, a method can include assigning one or more constraints to an upper surface, assigning one or more constraints to a lower surface, defining a pad configuration, generating pad locations locatable on the upper surface that conform to the defined pad configuration and the assigned constraints for the upper surface and the lower surface, and outputting specifications at least one of the generated pad locations. In such a method, assigning one or more constraints to an upper surface or a lower surface may include assigning one or more cost constraints or assigning one or more physical, environmental constraints. As an example, a lower surface may be a two-dimensional representation of a reservoir and an upper surface may be a two-dimensional representation of a ground or other surface (e.g., a surface suitable for one or more pad placement locations).

As to generating pad locations, a method may include generating locations based at least in part on parameter values determined by applying a probe to locations on the upper surface. Such a probe may be a two-dimensional probe (e.g., with a footprint based on one or more pad configuration definition specifications) or a three-dimensional probe (e.g., of an appropriate depth dimension to consider one or more features defined or definable within a subsurface volume). As an example, a method may include a combination of two-dimensional and three-dimensional probes.

As an example, a method may include defining a probe based at least in part on a defined pad configuration and applying the probe to locations on an upper surface to determine parameter values, for example, where such values can indicate whether or to what degree a location is acceptable for placement of a pad. As an example, a method may include generating pad locations locatable on an upper surface and ranking locations on the upper surface based at least in part on determined parameter values (e.g., as determined by applying a probe). As mentioned, other types of equipment may substitute for a pad and, as such, a probe may represent specifications, a configuration, etc., for equipment other than a pad.

As an example, constraints may be assigned to more than two surfaces or, for example, be defined in a three-dimensional manner and/or optionally defined with a dimension such as time (e.g., one spatial dimension and a time dimension, two spatial dimensions and time dimension, three spatial dimensions and a time dimension). As to a time dimension, consider a development, which may be planned or not but that may expand with respect to time, which may be a period of years. Where an operation or operations extend over a period of years, a constraint that varies with respect to time may be applied for one or more times. As to three spatial dimensions, where three dimensional constraint information is available (e.g., accessible via a data source, measurements, interpolation, etc.), as an example, a three-dimensional probe may be implemented. As an example, a three-dimensional probe may be implemented as a secondary process (e.g., fine tuning, confirmation, etc.), for example, to focus in on a region of concern after application of a two-dimensional probe.

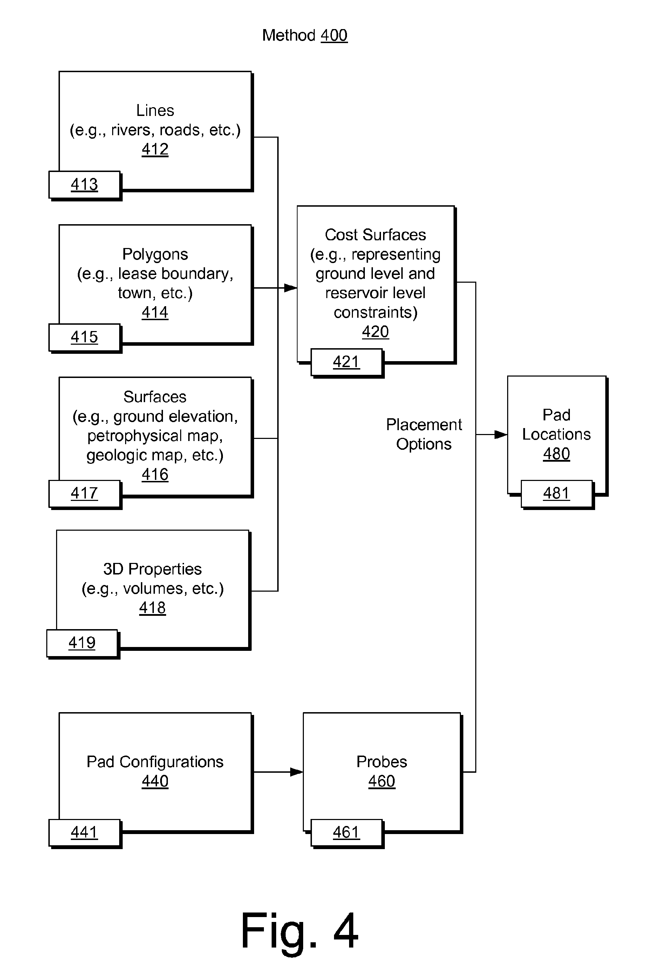

Fig. 4 shows an example of a method 400 for providing placement options for one or more pads. The method 400 includes various blocks 412, 414, 416 and 418 for assigning constraints as well as to define one or more pad configurations 441. As shown in the example of Fig. 4, the constraints are provided as input to a cost block 420 that forms one or more cost surfaces, for example, for a ground level and a reservoir level. Along another branch of the method 400, the pad configuration information is received as input to a probe block 460 that constructs a probe or probes to probe the one or more cost surfaces of the cost block 420. Upon application of the probe to the one or more costs surfaces, the method 400 can output placement options as pad locations, as indicated by a pad location or output block 480.

The method 400 is shown in Fig. 4 in association with various computer-readable media (CRM) blocks 413, 415, 417, 419, 421, 441, 461 and 481. Such blocks generally include instructions suitable for execution by one or more processors (or cores) to instruct a computing device or system to perform one or more actions. While various blocks are shown, a single medium may be configured with instructions to allow for, at least in part, performance of various actions of the method 400. As an example, a computer-readable medium (CRM) may be a computer-readable storage medium. One or more CRM block may be provided for graphical user interfaces (GUIs), etc.

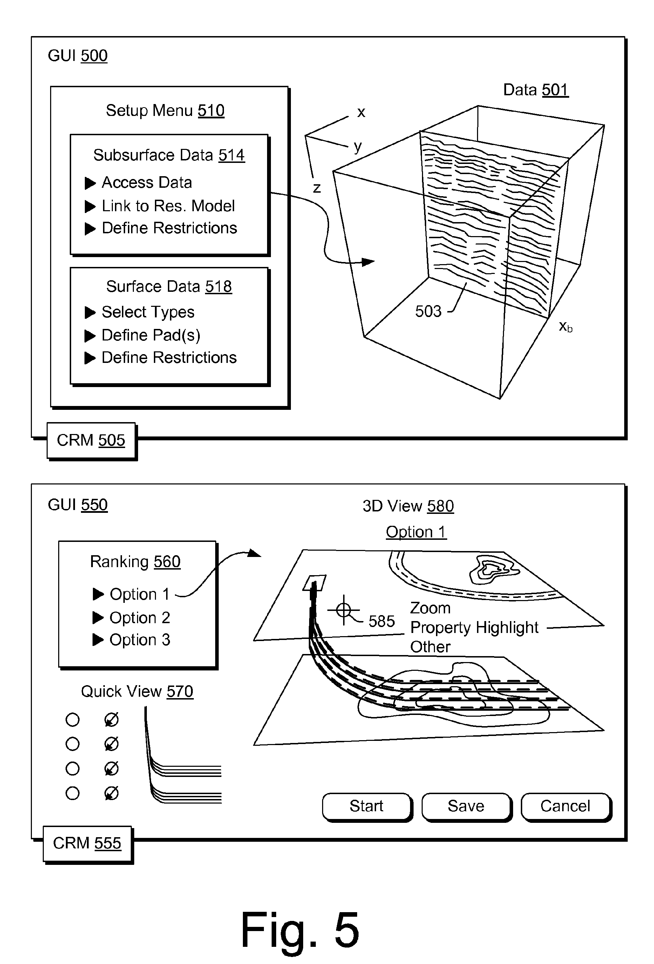

Fig. 5 shows examples of graphical user interfaces (GUIs) 500 and 550 for interacting with a pad placement process. In the GUI 500, a portion may present a representation of data 501 for an environment, for example, sliceable along various planes 503. Further, the GUI 500 may present a setup menu 510 that allows for input of subsurface data 514 and surface data 518. In Fig. 5, the GUI 550 may present various information related to output from a method such as the method 400 of Fig. 4. For example, a ranking graphic 560 may present a ranking of placement options, a quick view graphic 570 may present a simplified view of a placement option and a multidimensional view 580 may present details of a placement option, optionally responsive to selection of one of the ranked placement options via the ranking graphic 560. As shown, the graphic 580 may include a cursor 585 that allows for zooming, rotating, panning, display of properties, highlighting of properties, pad specifications, estimated pad costs, estimated pad building time, or other functions. In the example of Fig. 5, the quick view graphic 570 shows two sets of equipment, which may be, for example, equipment associated with a SAGD or other EOR operation.

The GUI 500 and the GUI 550 are shown in Fig. 5 in association with various computer-readable media (CRM) blocks 505 and 555. Such blocks generally include instructions suitable for execution by one or more processors (or cores) to instruct a computing device or system to perform one or more actions. While various blocks are shown, a single medium may be configured with instructions to allow for, at least in part, performance of various actions such as rendering, controlling, inputting, outputting, etc. As an example, a computer-readable medium (CRM) may be a computer-readable storage medium.

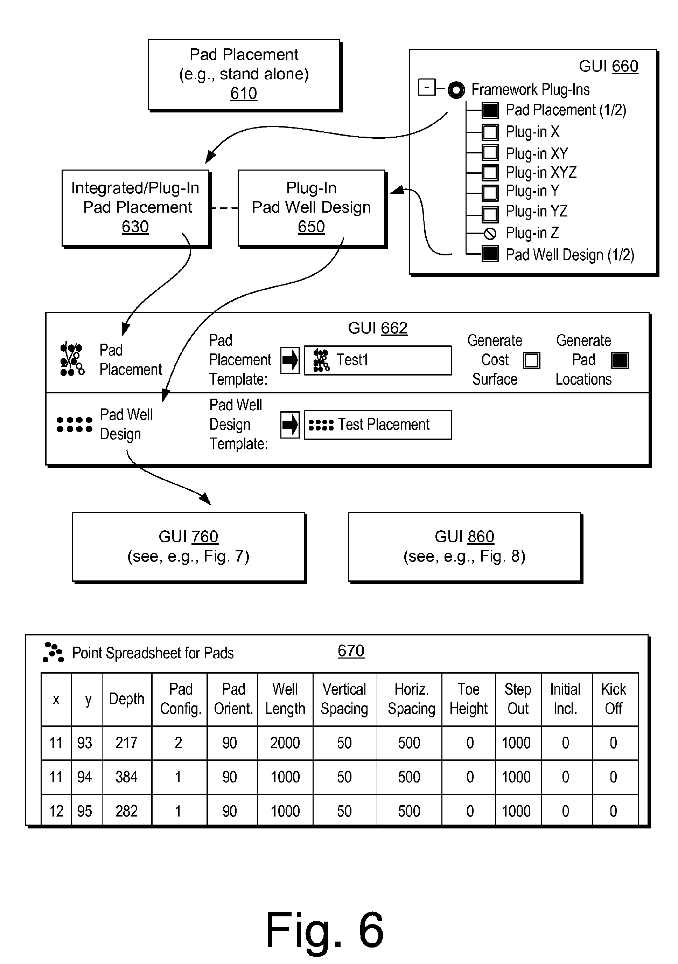

Various examples of graphical user interfaces (GUIs) are shown in Figs. 6 to 16. In such examples, a pad placement module (e.g., as a plug-in to a framework) may be used in conjunction with a pad well design module (e.g., as a plug-in to a framework). A graphic from a pad placement process may include markers that identify well head points, for example, resulting from an analysis that accounts for one or more constraints. Such a graphic may illustrate potential wells to be drilled from a well point or points and optionally one or more other features (e.g., other wells, obstacles, constraints, etc.). As an example, surface and reservoir restrictions may be show using color coding for features such as pre-existing wells, surface acreage available, a reservoir target area, roads, rivers, etc.

As an example, a pad placement module may operate in conjunction with a pad well design module in a manner that first identifies and characterizes possible surface pad locations, and second, creates one or more wells underneath a pad. A process may, for example, generate thousands of wells following restrictions at a ground level (e.g., an upper surface) and a reservoir level (e.g., a lower surface).

As an example, a pad placement module may interoperate with a framework such as the PETREL® framework, for example, to generate pad surface locations. As an example, a user may customize pad well configurations, restrictions pertinent to ground level and reservoir level, and create one or more cost schemes. A pad placement module may include functionality to perform one or more sensitivity studies, for example, on well length, orientation, etc. As an example, integration with a pad well design module may allow for creation of wells at one or more identified surface pad locations. As an example, a process for determining a field development plan can include performing one or more pad placement processes.

As to restrictions, as an example, one or more restrictions can be described using lines, polygons, regular surfaces, etc., and applied at, for example, a reservoir level (e.g., lower surface) or a ground level (e.g., upper surface). As an example, one or more cost functions may indicate where an allowable drilling area is or, for example, may implement a cost structure. As an example, a pad placement process may demonstrate cost to drill in relationship to one or more features (e.g., a pad being located closer to a river, a road, etc.). As to a geometric restriction, a pad placement process can include assigning a cost function (e.g., a cost structure).

As an example, a user may specify which pad configuration or configurations to use along with well parameters and one or more strategies for computations for a pad placement process. As an example, pad well parameters can be used to indicate total aerial space a pad configuration may occupy where, for example, the same parameters may be used with a pad well design module. As an example, a pad index attribute can optionally be created to indicate occupied pad locations and to show which pads have less than maximum well lengths. Such an attribute may be used with a pad well design module, for example, to help truncate one or more wells based on one or more pad placement restrictions.

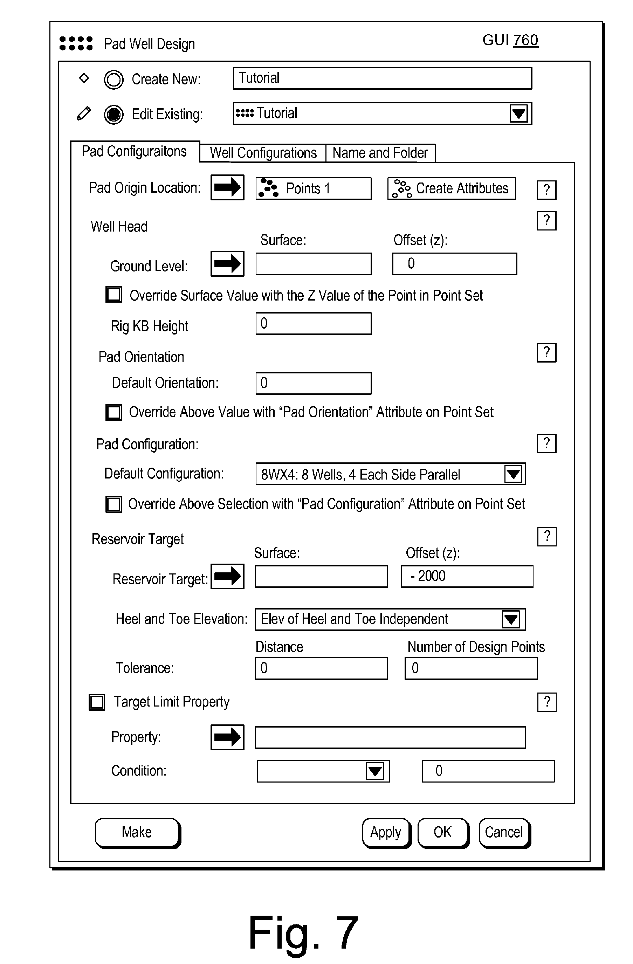

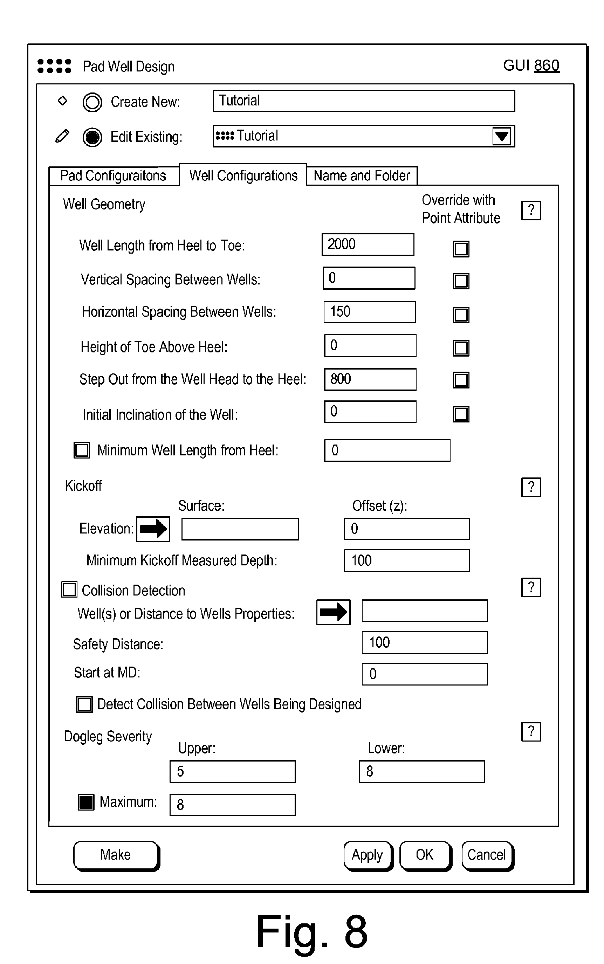

Fig. 6 shows examples of some modules 610, 630 and 650, graphical user interfaces 660, 662, 760 and 860 for pad placement and design and an example of a spreadsheet 670, which may be editable by a user or otherwise processed, analyzed, exported, etc. As shown, various implementations or arrangements are possible for pad placement modules. The pad placement module 610 may be a stand-alone module while the module 630 may be an integrated or plug-in module that optionally receives or transmits or otherwise exchanges data (directly or indirectly) with the module for pad well design 650. The GUIs 660 and 662 provide for selection of a pad placement or pad well design process. The GUIs 760 and 860 pertain to various aspects of pad well design, for example, as shown in Fig. 7 and Fig. 8, respectively.

As to the GUI 660, in the example of Fig. 6, it includes a framework plug-in option that extends a list of options in a tree type of arrangement. As indicated, a Pad Placement option and a Pad Well Design option are selected, along with various other options. The GUI 662 shows information and controls rendered for Pad Placement and Pad Well Design. As to Pad Placement, a template control may be activated to select a template (e.g., "Test1") and, for example, an option to generate a cost surface or an option to generate pad locations may be selected. As to Pad Well Design, a template control may be activated to select a template (e.g., "Test Placement").

Fig. 7 shows an example of the GUI 760. In the example of Fig. 7, control graphics provide for creation of a new pad well design or editing of an existing pad well design. The GUI 760 also includes tabs for rendering information and controls germane to pad configurations, well configurations and name and folder options. In the example of Fig. 7, the tab for pad configurations is selected. Rendered controls can include a pad origin location control for points and attributes, a ground level control for surface and offset, a rig height control, a pad orientation control, a control for pad configuration (e.g., number of wells, sides parameters, etc.), a control for a reservoir target for a surface, offset, heel and toe elevation, tolerance (e.g., distance, number of design points, etc.) and a control for one or more target limit properties (e.g., to select a property, assign a condition, etc.). Control buttons may be provided to "make" a pad well design, to "apply" selections and/or field entries, to "OK" selections and/or entries, to "cancel" selections and/or entries, etc.

Fig. 8 shows an example of the GUI 860. In the example of Fig. 8, control graphics provide for creation of a new pad well design or editing of an existing pad well design. The GUI 860 also includes tabs for rendering information and controls germane to pad configurations, well configurations and name and folder options. In the example of Fig. 8, the tab for well configurations is selected. Rendered controls can include a well length from heel to toe control, a vertical spacing between wells control, a horizontal spacing between wells control, a height of toe above heel control, a step out from a well head to a heel control an initial inclination of a well control, a minimum well length from heel control, kickoff controls for elevation and minimum kickoff measured depth, collision detection controls for well or distance to well properties, a safety distance, etc., and a dogleg severity control. Control buttons may be provided to "make" a configuration file, etc., to "apply" selections and/or field entries, to "OK" selections and/or entries, to "cancel" selections and/or entries, etc.

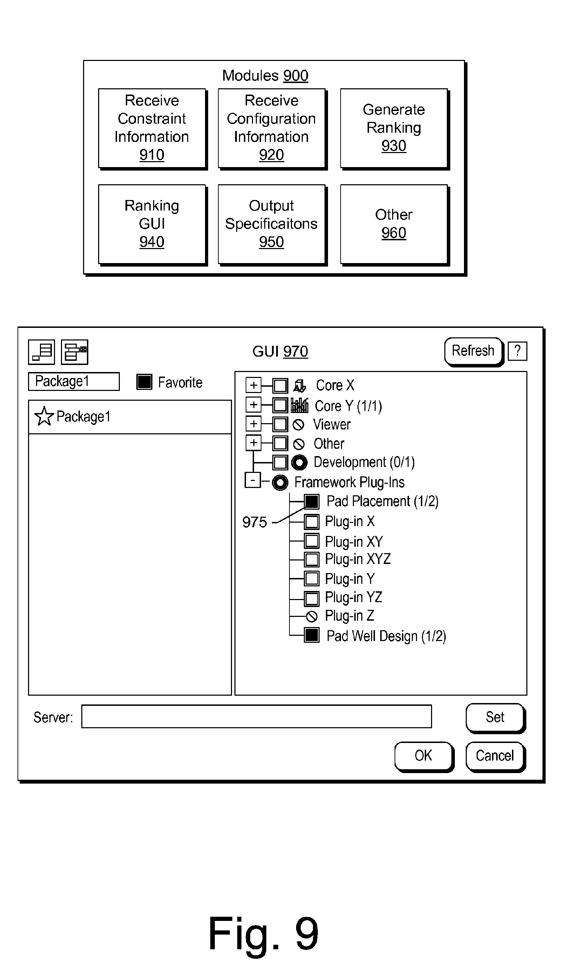

Fig. 9 shows example modules 900 and an example of a graphical user interface 970 that includes a pad placement option 975 implemented as a plug-in with respect to a framework. As an example, the modules 900 may be configured as one or more computer-readable media (e.g., storage media) with processor-executable instructions to instruct a computing system to: receive constraint information for a multilayer model of an environment (see, e.g., module 910); receive configuration information for a drilling pad (see, e.g., module 920); generate a ranking of drilling pad locations based on the constraint information, the configuration information and the multilayer model of the environment (see, e.g., module 930); present, via a graphical user interface, at least some of the ranked drilling pad locations (see, e.g., module 940); and output specifications for at least one of the drilling pad locations based on input received via the graphical user interface (see, e.g., module 950). One or more other modules 960 may be included in the modules 700.

As an example, a module may include instructions to instruct a computing system to output specifications to output a blueprint of a building site for building a drilling pad at one of the drilling pad locations, to output a building costs for building a drilling pad at one of the drilling pad locations, to output operational specifications for operation of equipment that may be placed via the drilling pad location, etc. A module may be provided that includes instructions to receive configuration information for a drilling pad where the information is for an offshore drilling pad.

As an example, a module or modules may be in the form of one or more computer-readable media that include processor-executable instructions that, for example, instruct a computing device, a computer, a computing system, etc. For example, one or more modules may instruct a device or system to generate a graphical user interface for selection of regional geometry constraints for an environment, generate a graphical user interface for selection of pad and well specifications for the environment, generate a graphical user interface for selection of pad placement options for placement of pads in the environment; and generate a graphical user interface for selection of presenting a cost surface or presenting pad locations.

As an example, one or more modules may instruct a device or system to generate a graphical user interface for selection of presenting a cost surface and presenting pad locations, to generate a graphical user interface for selection of a plug-in to perform a pad placement process, to generate a graphical user interface for designing a well pad, etc. As an example, one or more modules may be implemented as or form a plug-in to a framework.

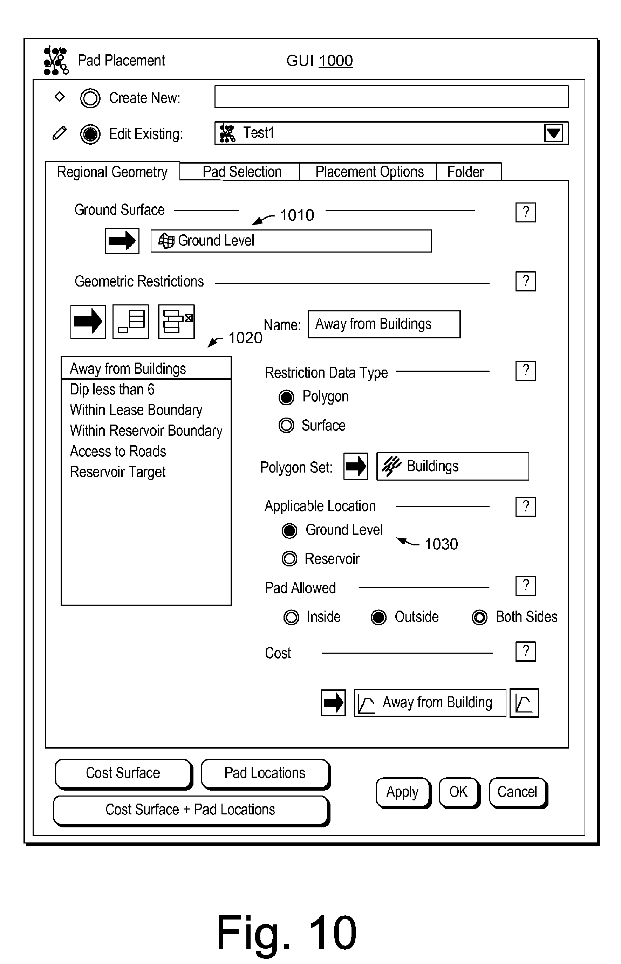

Fig. 10 shows an example of a graphical user interface 1000 for selecting geometric restrictions as inputs for a pad placement process (see, e.g., fields 1010, 1020 and 1030). In the example of Fig. 10, the ground surface or ground level field 1010 allows for specifying geometric restrictions, for example, as shown in field 1020 (e.g., away from buildings, dip less than 6, within lease boundary, within reservoir boundary, access to roads, and reservoir targets). The field 1030 provides graphical controls that allow for selection of applicable location, for example, a ground level or a reservoir (e.g., where the ground level may be an upper surface and the reservoir a lower surface). As mentioned, a probe may be defined and applied to various locations at an upper surface where restrictions of a lower surface are taken into account in assessing the various locations.

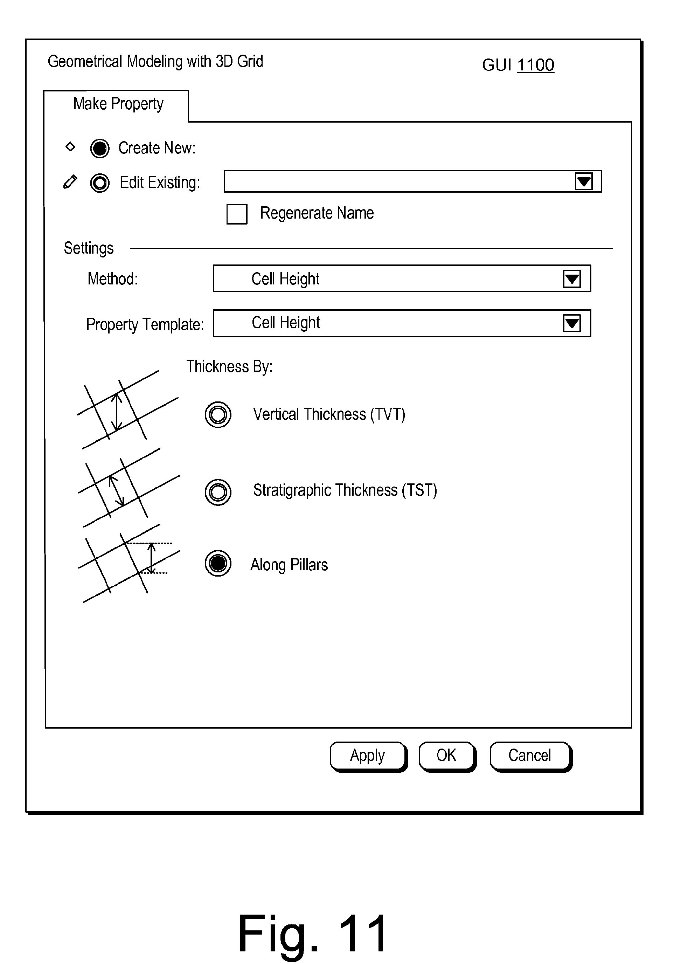

Fig. 11 shows an example of a graphical user interface 1100 for a property with respect to a three-dimensional grid (e.g., for defining a restriction). In such an example, a pad placement module can provide for creating a reservoir thickness surface attribute attained from a 3D grid property. A user may commence creation of the attribute by selecting a geometrical modeling process that renders the GUI 1100 to a display. In the example of Fig. 11, a field may appear for "cell height" and "method type" to generate a property called "cell height" (e.g., a model pane under a property folder). In response, a 3D window may open where the property may be toggled, for example, by selecting control next to the property's name. In such an example, color scaling may be implemented and optionally adjusted and a property filter function applied once a 3D grid has been selected. In a property filter control, a user may select a check box or other control to use a value filter in conjunction with a cell height property. In such an example, a user may adjust a scale for visualization of certain values, for example, greater than a selected value. In turn, a rendering algorithm may adjust property color such that a color change occurs to indicate that a filter is being applied. As an example, an option to make a map from a property may be presented and calculations may be applied on the filtered cells, for example, to create an average surface map (e.g., "average map for cell height"). Setting of the surface map may be available as well as a conversion process to convert information to a set of polygons along edge of a selected surface. As an example, a polygon set may be named "reservoir_boundary" and optionally moved into a "restrictions" folder (e.g., via a drag-and-drop operation). Thereafter, a user may access the created "reservoir_boundary" as a restriction in a pad placement process.

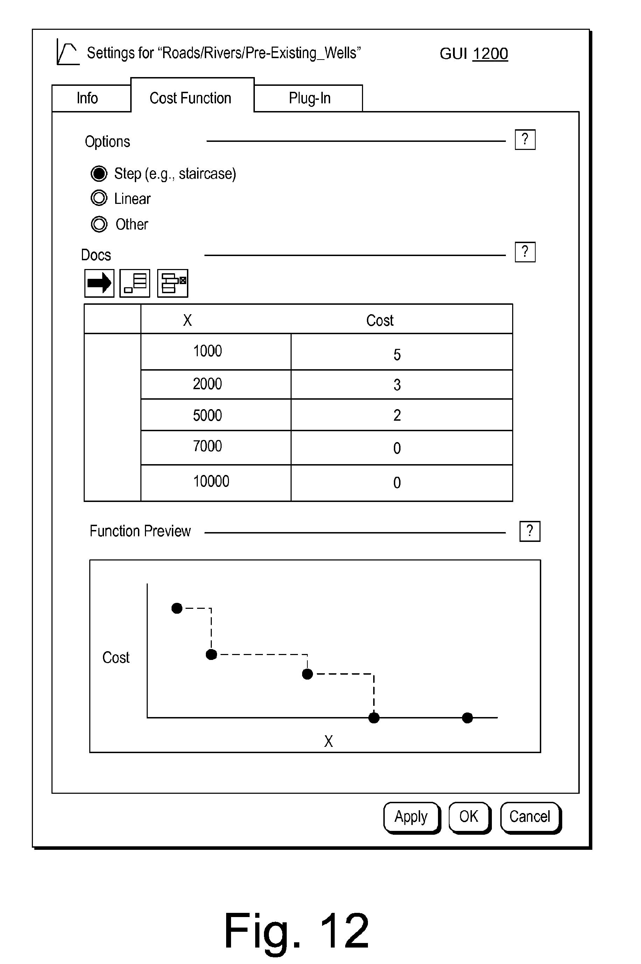

Fig. 12 shows an example of a graphical user interface 1200 for generating a cost function. As an example, a cost surface may aim to convey "drillable area" as where available pad locations are at an upper surface and a lower surface. In such an example, cost may be set to 0, for example, where a range of x-values denotes the closest a well can be drilled to an object or boundary. As an example, a scenario may indicate a ground level surface where there are no surface restrictions, and no costs tied to any attribute or border distance. In such an example, a drillable area may be an entire ground level surface, and the cost to drill may be 0 at any given location. Alternatively, as an example, a cost surface may contain more complexity. For example, other than indicating "drillable area," it may also show cost conventions with respect to surface and reservoir-defined parameters, like rivers, cities, reservoir thickness, dip angle, etc. Such an approach can provide a user with an ability to incorporate many real-life decision-pending drilling parameters into a pad placement process.

As an example, a process can include one or more cost functions specified for each geometric restriction added to the process. A cost function may be specified in arbitrary units, for example, where "x" describes a relative distance or property value range to be considered in the cost function versus the relative "cost". Such an approach can allow a user to create as many cost functions using a variety of inputs (either through a surface attribute, or polygons, or lines). For polygons, "x" may correspond to distance. For example, a cost scheme could be created where the closer a pad is to a corresponding object (e.g., an object such as in the PETREL® framework), the higher the cost of the pad/well. For example, a surface geometric restriction like "Rivers" may be represented by polygon lines. Logic may be conveyed as something like "we cannot drill within 500 feet of the river, it will be more expensive to drill within 500-1000 feet, and the cost will become less, the further we drill from the river". For such logic, "x" can refer to a 2D distance to the polygon lines that represent the "Rivers" restriction. To indicate that it is not practical to drill within 500 feet of the associated polygon lines "Rivers," the first "x" value may be 500. A default cost function may apply a 0 cost from an x-value of 0 to 10,000. If applied to polygon geometric restrictions, this means that a pad location can exist within 0 and 10,000 units from the dropped polygon. In such an example, a 0 x-value can be seen as a floor restriction and an x-value of 10,000 as a cap. In the example of Fig. 12, cost is shown as decreasing in a stepwise manner with respect to x.

As an example, a cost function can act to limit a drillable area, for example, where x-min and x-max values limit a proximity/range of "drillable" locations. In such an example, by limiting the minimum or maximum values of "x," a user has the ability to limit or enable available drillable areas at the surface and reservoir levels. As an example, a cost function can establish a cost scheme relative to a surface property (e.g., a cost function may be based on a surface attribute). In such an example, a surface attribute such as z-depth can be used to show an increased well cost based on depth. As an example, a surface may have a property like NTG defined that can be used in a cost function to indicate non-drillable locations at a surface level to be available where NTG is less than a cost value. As an example, a cost function can establish a cost scheme relative to proximity of polygon lines. For example, a process may include one or more of roads, pipelines, property lines, etc. and: (a) where both sides of a polygon are selected, a cost function may be applied to each side of the polygon line; (b) where an inside is selected, items outside of the closed polygon may not be considered and the cost function may be applied to the inside of the polygon (e.g., for use to describe a lease area, reservoir boundary or some other confining restriction); or (c) where an outside is selected, items inside of the closed polygon may not be considered and the cost function may be applied to the outside of the polygon (e.g., examples may include cities, airfields, residential areas, where drilling may not be allowed within a given representative polygon, and may be more expensive the closer a pad is to the given polygon boundary, etc.).

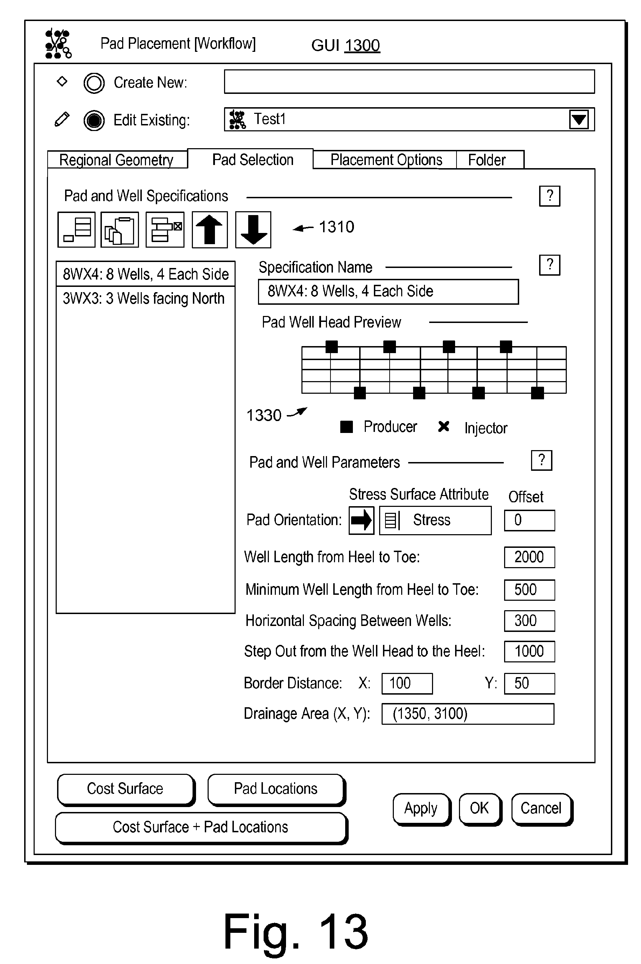

Fig. 13 shows an example of a graphical user interface 1300 for selecting pad and well specifications as inputs for a pad placement process (see, e.g., field 1310). For a selected input specification, a graphic 1330 may provide a representation as a pad well head preview. While pad selection is shown in the example of Fig. 13 (and various other examples), other type of equipment (e.g., structure, etc.) may be specified, configured, etc., and placement options provided (e.g., via execution of a probe-based method).

As an example, a pad placement process can consider a list of configurations sequentially: first, trying to use the first pad configuration, followed by the second configuration in the list, and so on. In such an example, if no pad configurations from the list are suitable, then a location may be left empty. As an example, a user may set up a process to start a list with the most desirable pad configuration to be considered first, the next most desirable pad configuration second, and so on, so that the least number of pads may be used to supply the most number of wells.

In the example of Fig. 13, the pad well head preview graphic 1330 may be generated by a pad placement module as a schematic to illustrate how different wells in a pad may be organized based on geometry specified, which may be, for example, in a form of an XML file (e.g., mark-up language). Such a graphic may show locations of individual wells with reference to a pad location (e.g., optionally via consumption of mark-up language or other instructions).

In the example of Fig. 13, for a pad selection tab of a pad placement process, a user may drop down or load the following well pad configurations 8WX4 and 3WX3; noting that other configurations can be added/edited (e.g., via an XML or other file). A user may, for a selected configuration, actuate a drop down for a stress attribute (e.g., stress direction) and review various associated parameters. As an example, a pad orientation field may provide for a pad's azimuth that indicates a degree orientation that a pad has and a sum of a surface attribute (e.g., dropped in the stress attribute field, plus the value in the offset field (e.g., by default it may be 0) can indicate an orientation for the pad. As an example, a placement options tab may allow for an option to automatically rotate a pad and to check various orientations (e.g., at specific increments) to determine a best orientation of a pad.

As to well length from heel to toe, this may be a length of a well from a heel point to a toe point of the well. Such a parameter may be used to determine a length of a horizontal lateral of a designed well. As to drainage area, this may be defined as a bounding box of points representing the heels and toes (e.g., on both sides). As an example, a drainage area calculation may be based on a 0 degree orientation, for example, to calculate a theoretical drainage area that may be affected by a well in a pad. As to a minimum well length from heel to toe, this may allow a user to set a minimum desired length, which if not met, may avoid well creation. If a default value of 0 is used, then the minimum well length may be a value entered in a well length from heel to toe field.

As to horizontal spacing between wells, such a parameter can specify spacing between heel (or toe) locations of two or more wells in a pad. As to step out from a well head to a heel, it may be a lateral distance allowed between a well head point and the heel point of a well trajectory. As an example, a border distance parameter may control minimum distance between wells in a neighboring pad (e.g., x and y distances that a nearest well from an adjacent pad may exist at with relation to the wells of a given pad).

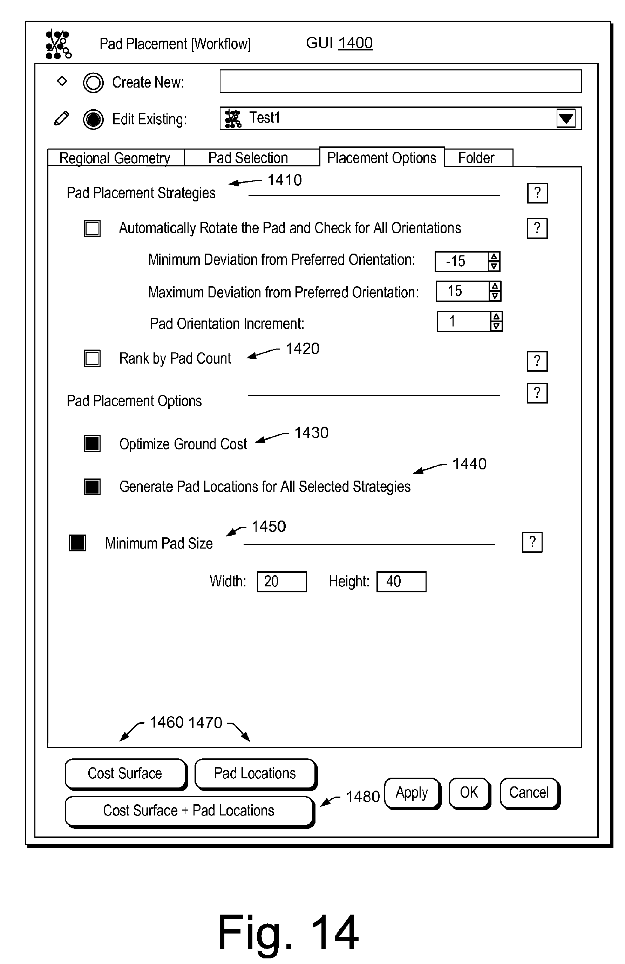

Fig. 14 shows an example of a graphical user interface 1400 for selecting placement options for a pad placement process (see, e.g., fields 1410, 1420, 1430, 1440 and 1450). Further control graphics or graphical controls 1460, 1470, and 1480 allow a user to select and a machine to receive instructions or commands to perform actions associated with a cost surface or surfaces, pad locations, or a cost surface or surfaces and pad locations.

As to "rank by pad count" (see, e.g., the field 1420), such a strategy may aim to further maximize a total pad count. For example, through such a selection, a number of top-listed pads that can be placed in an I-direction may be counted. Such a strategy may consider other combinations varying different applicable pad configurations in a pad selection list and, for example, select a best combination of pads (e.g., the option having the highest number of pad wells in the I-direction) as the final choice. Such a strategy first determine if a surface's I-direction coincides with a pad well orientation, for example, to see if a mismatch exists, which may impact a rank by pad count process.

As to "optimize ground cost" (see, e.g., 1430), as an example, a pad placement process may perform a cost minimization that will not remove pads, since a goal of the pad placement process may be to maximize reservoir contact, but rather will shift existing pad locations to reduce the total cost, if possible. For example, within the same increment a pad may be shifted from a ground location with a surface cost of 10 to a location with a surface cost of 8. In such an example, a new pad location after cost optimization may, for the same reservoir coverage, demonstrate a lesser cost.

As an example, a cost optimization process may be iterative as moving a pad from one location to another may enable additional movements for one or more pads nearby. As an example, a module can determine whether an iteration results in a lower cost, for example, such that if the module's process is stopped before it is complete, the module can output pad locations that bear no higher cost than the pad locations without the optimization. Such a process may be useful in demonstrating cost sensitivity between two potential pad locations. However, a first priority may be to maximize contact with a reservoir surface (e.g., a lower surface); thus, cost optimization may be applied as an adjustment to strategy-generated points.

As to "generate pad locations for selected strategies" (see, e.g., the field 1440), such an option can show pad locations for each selected strategy. As an example, if this option is not toggled on, a case with highest reservoir coverage may be output as a final pad locations point set.

As to "minimum pad size" (see, e.g., 1450), this may be used for selection of dimensions of a minimum pad size. For example, for a rectangular pad, a width and height may be provided; whereas, for a circular pad, a radius may be provided. Such an option may operate in conjunction with a pad geometry, for example, to display appropriate options that can define a minimum pad size.

As to the control 1460, this can initiate generation of cost surfaces for a ground level (e.g., upper level) and for a reservoir level (e.g., lower level). As an example, resulting surfaces can be found in a folder, for example, in an input pane. As an example, surfaces may be toggled on one at a time (e.g., in a 2D or 3D window) to verify that geometric restrictions were used in an intended way, for example, that the ground cost surface shows no cost surface area within it.

As to the control 1470, this can initiate generation of pad surface locations, for example, represented by a point-set. As an example, such a set may be visualized in a in a 2D or 3D window with surface restrictions to see how the pad locations were chosen with respect to these restrictions. In such an example, distance between a pad location and a restriction polygon may be viewed while referring to a respective cost function input. As an example, a pad placement point-set may be dropped into a pad well design input field. In such an example, well trajectories deviating from the pad well head may be created. As to the control 1480, this may be used to initiate both generation of cost surfaces and generation of pad surface locations.

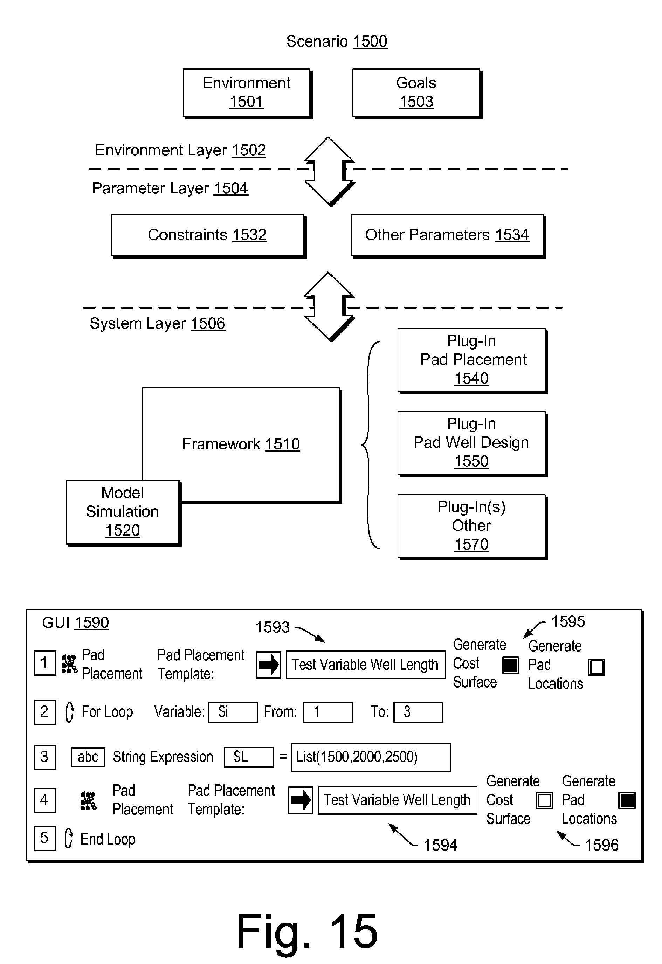

Fig. 15 shows an example of a scenario 1500 that includes an environment layer 1502, a parameter layer 1504 and a system layer 1506. In the example of Fig. 15, the environment layer 1502 accounts for an environment 1501 and goals 1503 associated with that environment. For example, the environment 1501 may be a field (e.g., including subsurface) that includes one or more reservoirs and the goals 1503 may be financial or other goals related to exploration, extraction, storage, etc., with respect to the field. The parameter layer 1504 includes constraints 1532 and other parameters 1534, which may be derived from the environment layer 1502. For example, if one of the goals 1503 is to drill a well in the environment 1501, then the parameter layer 1504 may include parameters (e.g., constraints or other) that characterize a pad configured to perform drilling.

In the example scenario 1500 of Fig. 15, the system layer 1506 includes a framework 1510 and a model simulation module 1520 where the framework 1510 can interact with one or more plug-ins such as a pad placement plug-in 1540, a pad well design plug-in 1550, and one or more other plug-ins 1570. For example, the framework 1510 may be or provide at least some features of the OCEAN® framework and the model simulation module 1520 may be or provide at least some features of the PETREL® simulation software framework.

As an example, the system layer 1506 may receive parameter values from the parameter layer 1504 and perform simulations where the simulations rely on input of at least some of the parameter values to one or more of the plug-ins 1540, 1550 and 1570. Output from a simulation may be directed to the parameter layer 1504, for example, for purposes of a sensitivity analysis, optimization, etc., and optionally to the environment layer 1502, for example, for purposes of gathering more information about the environment 1501, selecting another environment, adjusting or revising one or more goals 1503, or a combination thereof.

As to a sensitivity analysis, an example of a graphical user interface 1590 provides for testing variable well length via template input fields 1593 and 1594 according to options provided in selection boxes for cost surface generation 1595 and pad location generation 1596. Such an analysis can be integrated into the scenario 1500 with respect to the system layer 1506 and the other layers 1502 and 1504. The output of a sensitivity analysis may link environment 1501 and goals 1503 with respect to particular pad placement options, for example, based on constraints for acceptable pad configurations. As to the example of the GUI 1590, it demonstrates a script (see, e.g., 1, 2, 3, 4, and 5) that can set a well length to a list of values (1500, 2000, 2500) and generate pad locations, given each of these well lengths, to determine how sensitive pad locations are to such variations in well length.

As to optimization, as shown, the framework 1500 can interact with the plug-ins 1540, 1550 and 1570 and the simulation module 1520 to optimize one or more parameter values of the parameter layer 1532. For example, if a particular one of the goals 1503 is economic, then a cost function may be provided that depends on one or more of the parameters of the parameter layer 1506 where the framework 1510 optionally interacts with the plug-in 1570 that includes the cost function such that simulations, or more generally calculations, are performed in an iterative or other manner to maximize or minimize the cost function (e.g., depending on how the function may be cast). Once the cost function is optimized, for example, via interaction between the framework 1510 and the plug-in 1570 and optionally other layers 1504 and 1502, optimized parameter values as well as cost may be communicated or presented in a manner for consideration with respect to the environment 1501 and the goals 1503.

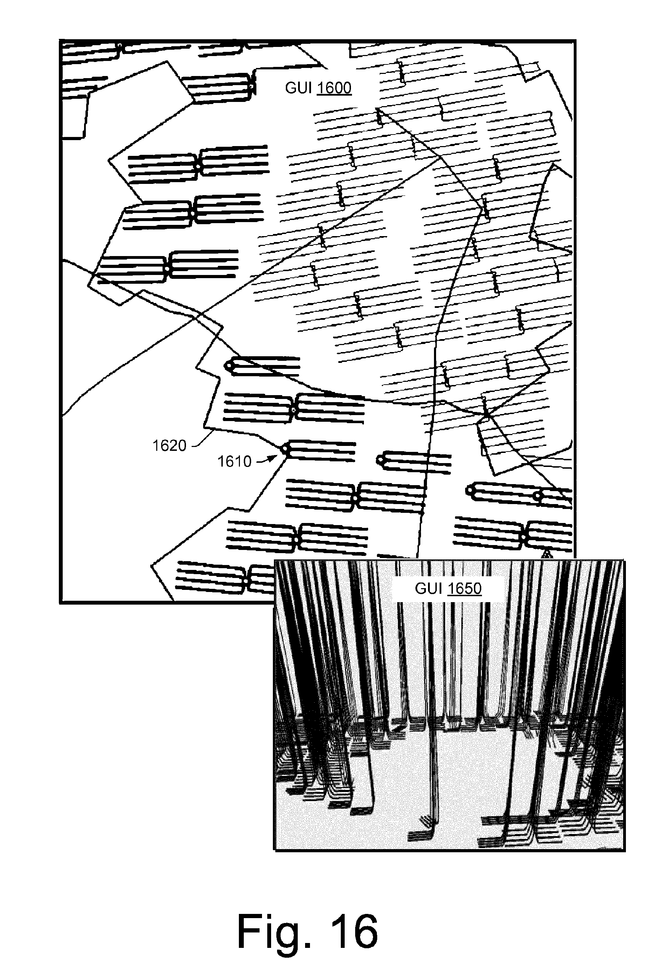

Fig. 16 shows an example of a graphical user interface 1600 and an example of a graphical user interface 1650. In the example of Fig. 16, various lines are shown with respect to well points, which include wells extending therefrom. A pad placement process may, for example, provide data for rendering in such a manner to visualize output from the process and various constraints with respect to the output. In the example GUI 1600 of Fig. 16, a well point 1610 is shown as including various well paths extending in a direction away from a boundary 1620, for example, which may represent a reservoir boundary, a lease boundary, etc.

The GUI 1650 of Fig. 16 illustrates a portion of a plan in a perspective view where, for example, various wells trajectories are illustrated as extending to a target region (e.g., consider a reservoir region).

As an example, various well points, boundaries, etc., may be selected (e.g., via an input device such as a mouse, a touch screen, etc.) where options may be presented in a menu or other form, for example, to view additional information, to edit information, etc. As an example, a tool may be available to position, rotate, etc., one or more well points, paths, boundaries, etc., optionally for consideration as input to a revised plan.

As an example, a plan may be for a production of one or more fluids (e.g., oil, natural gas, etc.). As an example, a plan may be for a play that includes oil and gas resources where such a play may be characterized at least in part by one or more of porosity, permeability, fluid trapping mechanism, etc. As an example, a play may include one or more of a sandstone reservoir, a carbonate reservoir, a coalbed methane reservoir, a gas hydrates reservoir, a shale gas reservoir, a fractured reservoir, a tight gas sands reservoir, etc.

As an example, a method may aim to minimize surface impact of a development plan where, for example, pad-based drilling is utilized. As an example, multiple wells may share a pad and deviate as they travel outward from the pad surface location in a manner that aims to increase the reservoir drainage area.

As an example, a drainage area may be defined as a reservoir area or volume drained by a well or wells (e.g., of a common pad). As an example, a drainage area may be calculated for a plurality of wells that emanate from a plurality of pads.

As an example, drainage area may be defined as a boundary of points representing heels and toes of wells associated with a pad, for example, plus one or more bounding distances (e.g., consider a bounding or border distance Bx in an x-direction and a bounding or border distance By in a y-direction).

As an example, a pad configuration may include one or more border parameters that may specify one or more border distances. As an example, a border distance can control the minimum distance between wells in a neighboring pad. For example, consider an x-distance and a y-distance that the nearest well from an adjacent pad may exist at with relation to the wells of a given pad. As an example, a border distance may use twice a specified distance to provide a relative proximity that pad wells have to one another.

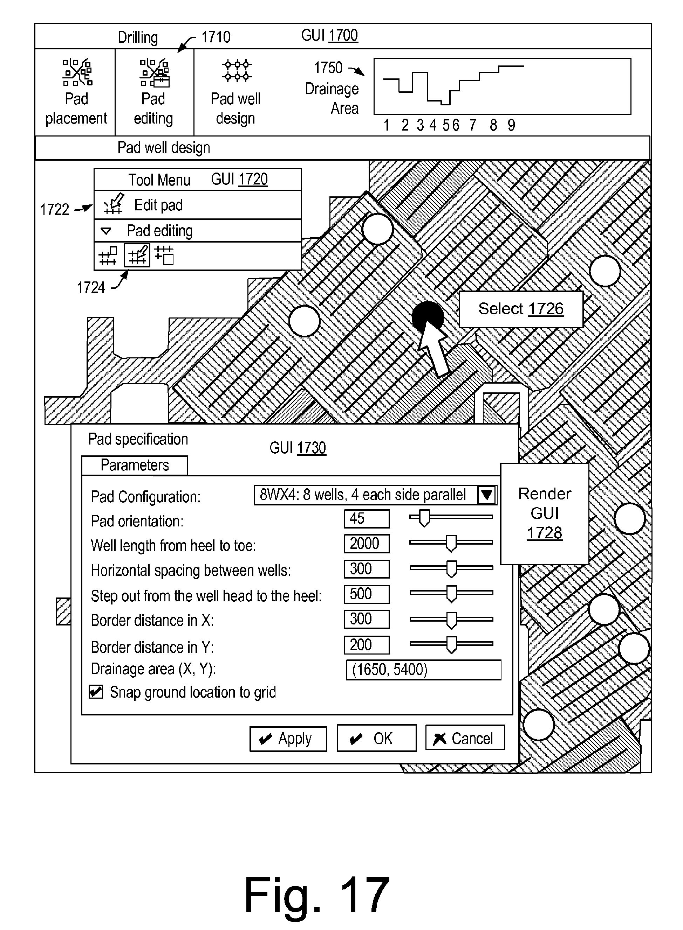

Fig. 17 shows an example of a graphical user interface (GUI) 1700 that can be rendered to a display and that includes various features that can be implemented to, for example, add a new pad to a plan, edit an existing pad and delete an existing pad. For example, a computing device may receive input to select a pad editing control 1710, which may cause the computing device to render a graphical user interface (GUI) 1720 to a display, which may be a tool menu that lists various tools available for pad editing (e.g., an edit pad tool, an add pad tool, a delete pad tool, etc.). In the example of Fig. 17, the GUI 1720 is rendered over an example of a portion of a plan that includes cost surfaces, pads, etc. Upon receipt of input corresponding to a tool item of the GUI 1720 to select a particular pad editing tool, the computing device can enter an operational mode that enables a user to manipulate the particular pad editing tool, for example, via a mouse, a touchscreen, a trackball, voice commands, etc. As an example, an operational mode may include one or more features for on-site editing, which may be, for example, via an individual on-site with a device, via a remote device (e.g., a land robot, a drone, etc.), via an individual on-site with a device that can control a device (e.g., a robot, a drone, etc.), etc. As an example, at least a portion of a plan may be rendered to a display along with on-site information (e.g., location information, on-site imagery, etc.).

As an example, consider a method implemented in a pad editing operational mode where a computing device can receive input that selects a particular pad, for example, as indicated by a selection block 1726. In response to a selection, the method may include rendering a graphical user interface (GUI) 1730 to the display, for example, as indicated by a render block 1728, where the GUI 1730 includes fields that are populated with values that correspond to the selected pad.

As an example, the selection block 1726 can include highlighting a selected pad, for example, by color coding at least a portion of the pad, flashing at least a portion of the pad (e.g., flickering, etc.), altering thickness of at least a portion of the pad, etc. Such highlighting may persist while a user navigates the GUI 1700, for example, to make one or more adjustments with respect to the GUI 1730.

As an example, a user may adjust one or more values of the GUI 1730, optionally in an iterative manner. In such an example, a drainage area associated with the selected pad may be automatically updated. As an example, a graphical user interface (GUI) 1750 may display drainage area values for iterative adjustments to the selected pad. For example, the GUI 1750 shows drainage area for nine adjustments, such an approach may allow a user to visual a trend in adjusting one or more values to achieve a desired or an acceptable drainage area for a selected pad. As an example, the GUI 1750 may be a "history" GUI that allows for selection of a portion of the GUI 1750 to populate (e.g., reset) a pad to corresponding values, for example, in the GUI 1730.

In the example of Fig. 17, as mentioned, the GUI 1700 displays various cost surfaces, for example, as areas of a particular color, hatching, etc. In such an example, an adjustment made via the GUI 1730 to a selected pad may be prohibited where a cost surface is encountered. For example, if a pad orientation of a pad would place a footprint of the pad in a particular cost surface area (e.g., to overlap the cost surface), the orientation may be not effectuated. As an example, a slider control for pad orientation may be limited to a range of orientations where the range is based at least in part on one or more cost surface. As an example, one or more slider controls may be limited at a lower end, an upper end or at lower and upper ends based at least in part on one or more cost surfaces.

As an example, a workflow can include a computing device receiving input to display cost surfaces in a multidimensional graphical user interface to a display along with an existing pad placement plan (see, e.g., the GUI 1600 of Fig. 16). In such an example, the workflow can include receiving input that activates one of a plurality of operational modes. For example, consider a plurality of operational modes that include an operational mode that can add a new pad to the plan, an operational mode that can edit an existing pad, and an operational mode that can delete an existing pad.

As an example, an operational mode that can add a new pad may cause a computing device to render a GUI to a display that provides for receipt of input to select an existing pad configuration and, for example, to specify one or more parameters applicable to a new pad, such as, for example, one or more of orientation, lateral length of a well, horizontal spacing of a well, etc. In such an example, in a multidimensional visual rendering of a plan, an interactive circle or sphere may be displayed at a location that corresponds to a selected pad and, for example, one or more lateral wells and/or an outline of a drainage area or drainage areas may be rendered to the display. In such an example, as a user interacts with an input mechanism of the computing device, one or more changes may be made to, for example, pad configuration, one or more parameters (e.g., orientation, well lateral length, well laterals, etc.), etc. In response to such one or more changes, the computing device can automatically revise a rendered visualization of at least the selected pad, for example, to display a revised outline of one or more drainage areas. As mentioned, drainage area information may be rendered to a GUI such as, for example, the GUI 1750, which may allow a user to detect a trend in drainage area.

As an example, a computing device may automatically calculate one or more drainage area related values (e.g., a drainage area value, a drainage area boundary location, a drainage area length, a drainage area width, etc.) responsive to receipt of input associated with a pad of a plan. And, the computing device may automatically render a visual representation of the drainage area to a display based at least in part on at least one of the calculated one or more drainage area related values.

As an example, an operational mode may allow for dragging a newly designed pad to a different location and, for example, to continue making adjustments to one or more parameters until a user deems the new pad to be acceptable as to one or more design goals. In such an example, the operational mode can include an "apply" (e.g., "accept") mechanism such as a graphical control of a GUI (e.g., an "apply" button) that causes a computing device to store a plan (e.g., as a revised or edited plan). For example, a method can include, when a user confirms adding new pad, creating a new pad placement plan or updating a current pad placement plan with the new pad location and parameters ensuring that one or more associated wells satisfy cost surfaces (e.g., a ground cost surface and a reservoir cost surface).

As an example, an operation mode for updating an existing pad can allow for input to a computing device such as a "click" on a pad location in a multidimensional GUI rendered to a display where, for example, a control GUI is rendered to the display (e.g., or another associated display) that provides for adjusting one or more parameters applicable to the selected pad.

As an example, an operational mode for adding a new pad can include instructing a computing device to render a multidimensional GUI to a display that shows well laterals and an outline of a drainage area (e.g., or drainage areas) associated with a pad where, for example, displayed information may be dynamically updated to reflect the latest location of the pad and associated parameters (e.g., as specified by a user). In such an example, where input is received by the computing device that acts to confirm one or more changes to a selected pad location, the operational mode can update a pad placement plan with the new pad location and associated parameters.

As an example, one or more operational modes can include processing one or more values, locations, etc. prior to committing a change to a plan. An operational mode for creating and/or editing of one or more pads may, before applying changes to a plan, perform one or more checking operations that act to ensure that one or more cost model boundaries are satisfied, that collision with one or more other wells is avoided and/or that collision with one or more other pads is avoided. As an example, for boundary conditions, one or more wells may be truncated to satisfy a cost model.

As an example, in an operational mode for deleting an existing pad, a computing device may receive input such as, for example, a "click" or touch input on a pad location in a multidimensional GUI rendered to a display. In response to such input, the computing device may re-render the multidimensional GUI to the display without the selected pad, as deleted. In such an example, a change to a plan may be confirmed, optionally without checking one or more constraints (e.g., cost surfaces, etc.).

As explained with respect to various GUIs and blocks of Fig. 17, a workflow may enable a user to visually create a new pad placement plan or modify an existing plan through interactions where constraints that defined at a ground level (e.g., a ground surface) and at a reservoir level (e.g., a subterranean surface) are met.

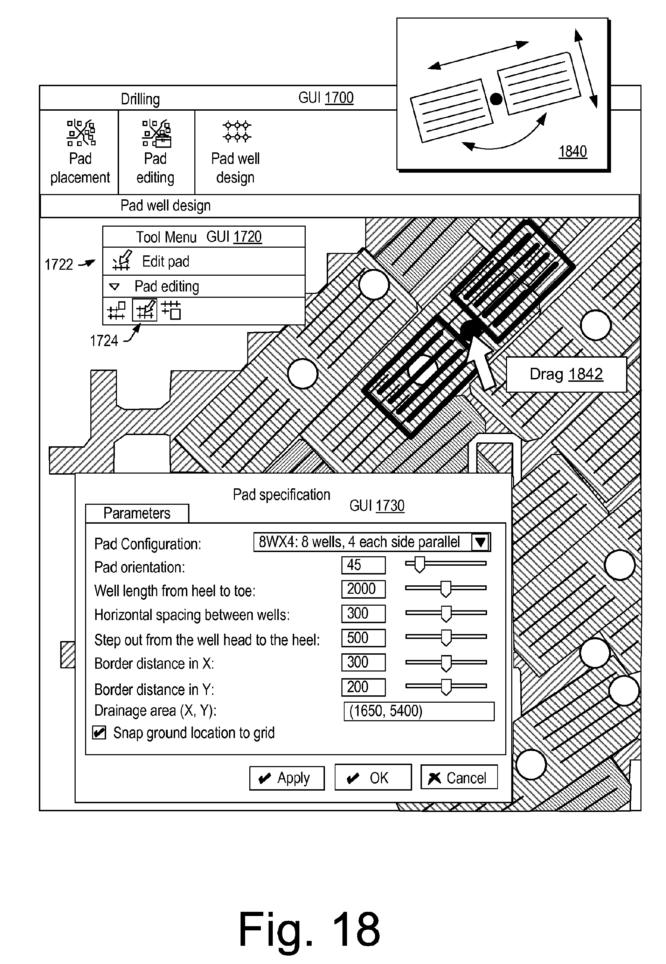

Fig. 18 shows the GUI 1700 of Fig. 17 along with a graphic 1840 that illustrates various types of movements for a pad. For example, a pad may be shifted in one or more dimensions and/or rotated. As an example, a pad may be shifted with respect to a surface that may be represented in two dimensions (e.g., a substantially flat surface). As an example, a pad may be shifted with respect to a surface that may be represented in three dimensions, noting that a pad construction process may act to "flatten" a sloping terrain, etc. (e.g., to create a relatively level pad). In the example of Fig. 18, a drag block 1842 is illustrated where, for example, a computing device may receive input to select and drag a particular pad. In such an example, the selected pad may be highlighted and, if an attempt is made to drag the pad over a prohibited surface, the selected pad may be blocked from such a move. As an example, one or more prohibited features may be highlighted to guide a user as to permissible moves of a pad that is to be dragged and dropped.

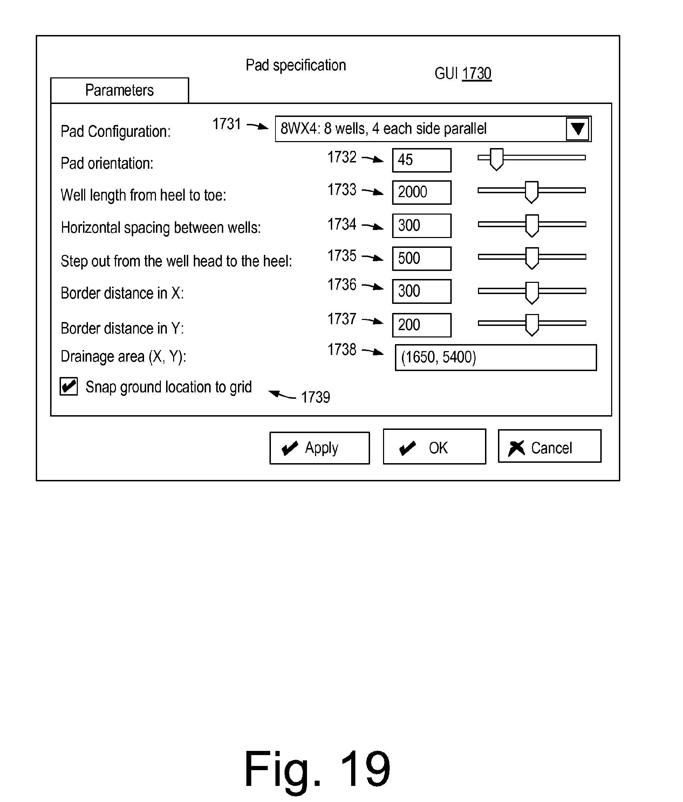

Fig. 19 shows the example GUI 1730 of Fig. 17. As an example, a GUI may include one or more of the features of the GUI 1730 and, for example, optionally one or more other features. As shown in Fig. 19, the GUI 1730 includes a pad configuration control 1731, a pad orientation control 1732, a well length from heel to toe control 1733, a horizontal spacing between wells control 1734, a step out from well head to heel control 1735, a border distance in a first dimension control 1736, a border distance in a second dimension control 1737, a drainage area field 1738 and a snap ground location to grid control 1739. In the example of Fig. 19, the various controls may be considered to be associated with parameters such as pad specification parameter; noting that various parameters pertain to one or more wells (see, e.g., "8 wells, 4 each side parallel").

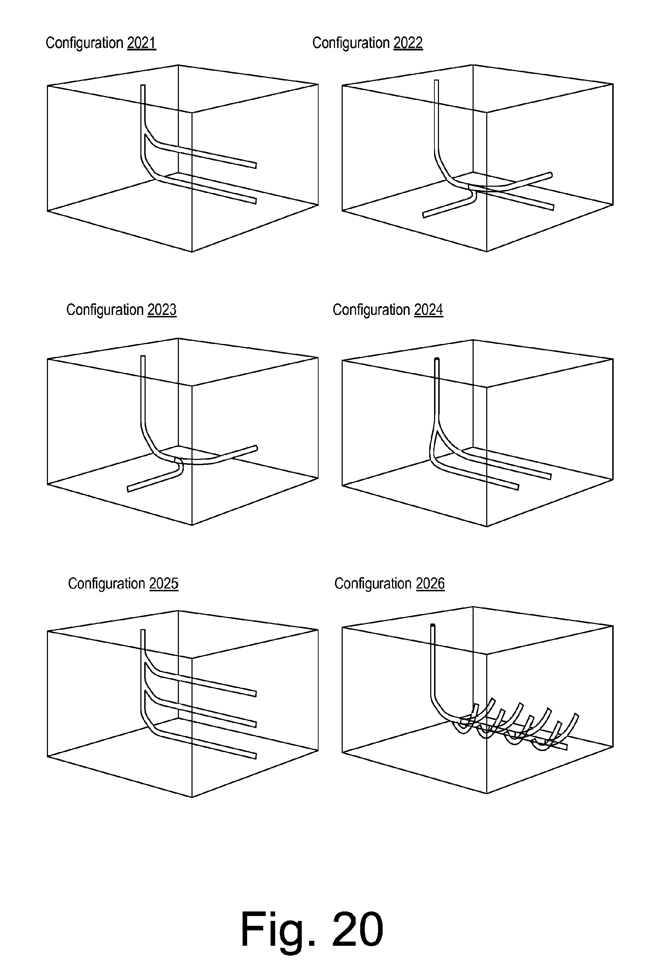

Fig. 20 shows various examples of some well configurations 2021, 2022, 2023, 2024, 2025 and 2026. As an example, a GUI may include a menu or other type of control that allows for specifying a well configuration such as, for example, one or more of the well configurations of Fig. 20. As an example, the pad configuration control 1731 of the GUI 1730 may include a drop down menu that includes one or more types of pad configurations that may include one or more of various types of wells.

As an example, a pad configuration may be specified using a mark-up language scheme. For example, a pad configuration specified in an XML scheme as follows:

```
 <WellPadConfigurations>
      <pad name="8 wells, 4 each side parallel">
             <wells>
                   <well ID="1" type="Producer">
                         <point Y="-10*U" X="15*U" Z="G" type="head"/>
                         <point Y="-P" X="S*1.5" Z="E" type="heel"/>
                         <point Y="-P-L" X="S*1.5" Z="(E+H)" type="toe"/>
                   </well>
                   <well ID="2" type="Producer">
                         <point Y="-10*U" X="5*U" Z="G" type="head"/>
                         <point Y="-P" X="S*0.5" Z="E" type="heel"/>
                         <point Y="-P-L" X="S*0.5" Z="(E+H)" type="toe"/>
                   </well>
             </wells>
      </pad>
 </WellPadConfigurations>
```

As an example, a scheme can include an element such as a <point directive=value ... /> element. Such an element can describe a control point on a designed well associated with a pad, for example, in a pad local coordinate system. Such a coordinate system can have an origin at pad surface coordinates, with the pad Y-axis rotated to the orientation of the pad.

As an example, an element can include one or more directives such as: X Cartesian X coordinate; Y Cartesian Y coordinate; Z Cartesian or cylindrical Z coordinate; R Cylindrical radial coordinate; T Cylindrical theta coordinate; A Azimuth of the well control point; I Inclination of the well control point; Type Takes the value Head, Heel, Toe (e.g., a point for each of Head, Heel, & Toe for each well where, optionally, additional points may be specified.

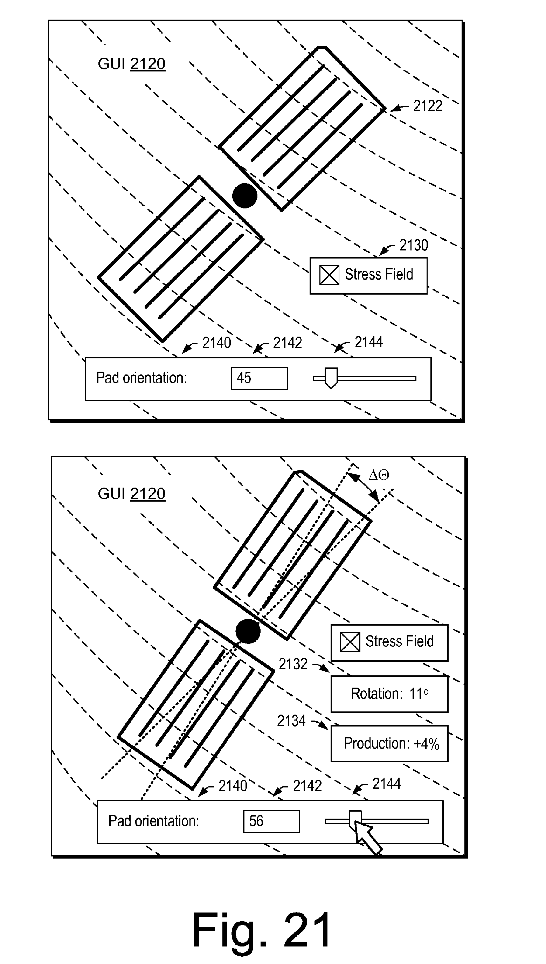

Fig. 21 shows an example of a graphical user interface (GUI) 2120 that includes a pad graphic 2122 and stress field information per selection of a stress field graphic 2130. The GUI 2120 also shows a pad orientation control 2140 that includes a numeric field 2142 for display of an angle (e.g., and optional direction entry of an angle) and a slider control 2144 that may be adjusted to orient the pad graphic 2122 (e.g., and change a numeric value in the numeric field 2142).

As an example, a computing device may receive input via the pad orientation control 2140 or, for example, via a touch or other type of input that causes rotation of the pad graphic 2122 (e.g., about a center point, etc.). In response to such input, one or more additional graphics may be rendered, for example, consider a rotation graphic 2132 that indicates a number of degrees of rotation and a production graphic 2134 that indicates a decrease or an increase in production associated with the number of degrees of rotation. As an example, a goal may be to orient one or more wells associated with a pad such that the one or more wells have a particular orientation with respect to a stress field. In such an example, the goal may facilitate one or more of wellbore stability (e.g., from collapse, etc.), hydraulic fracturing, etc.

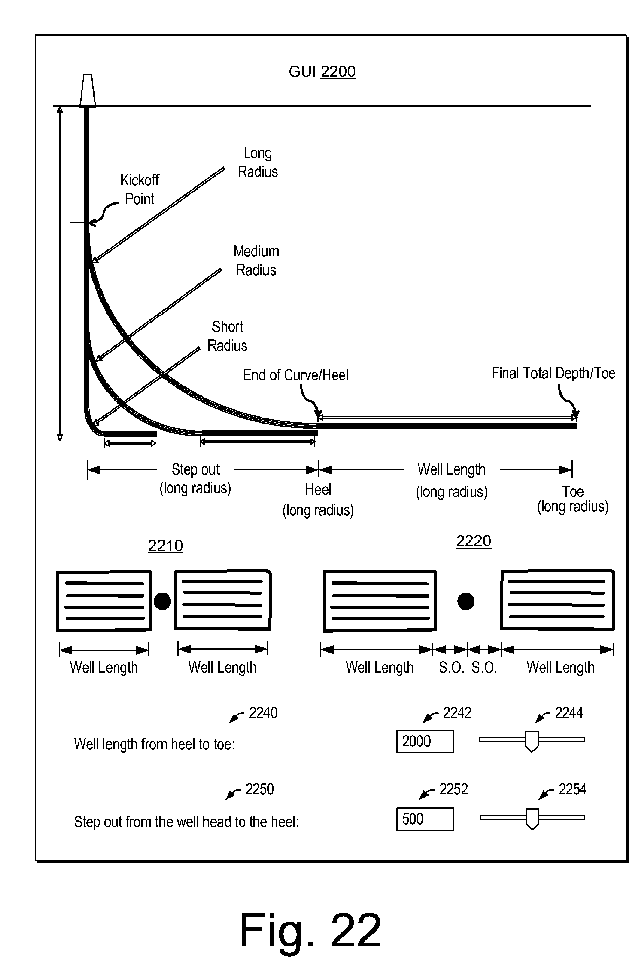

Fig. 22 shows an example of a graphical user interface (GUI) 2200 that illustrates various parameters associated with a well or wells. Also shown in the GUI 2200 are graphics 2210 and 2220, a well length from heel to toe control 2240 with an associated numeric field 2242 and slider control 2244 and a step out from the well head to the heel control 2250 with an associated numeric field 2252 and slider control 2254. As an example, a computing device may receive input via the control 2240 and/or the control 2250 and adjust a graphic representation of a pad and wells. For example, consider the graphic 2210 and adjustments that act to increase well length and to increase step out such that the computing device renders the graphic 2220 to a display, for example, as part of a multidimensional GUI for a pad plan.

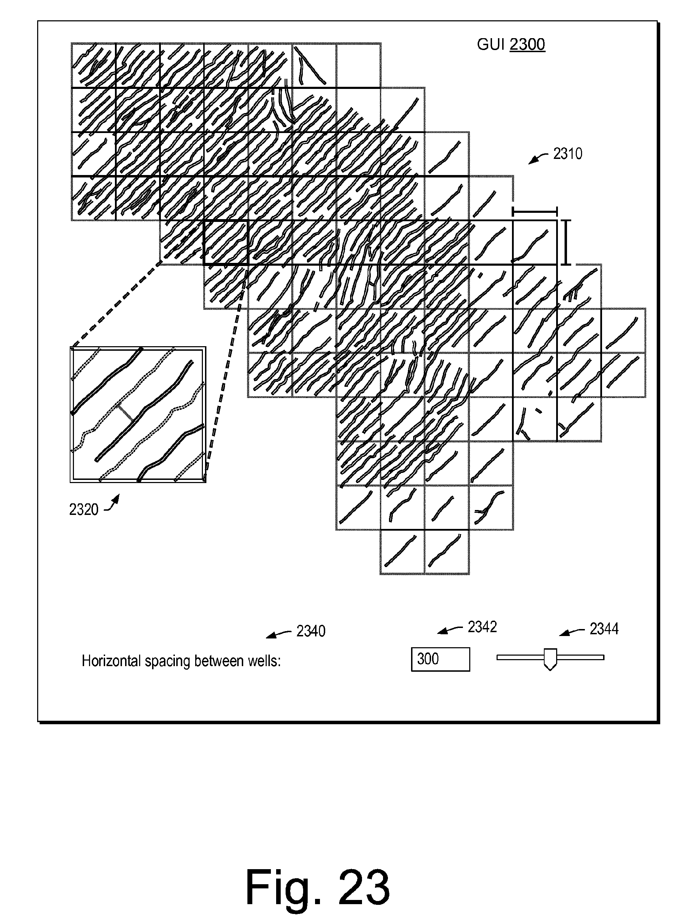

Fig. 23 shows an example of a graphical user interface (GUI) 2300 that illustrates a plan 2310 that is gridded where a grid 2320 can include wells that are spaced according to a well spacing parameter. In the example of Fig. 23, the GUI 2300 also includes a horizontal spacing between wells control 2340 with an associated numeric field 2342 and a slider control 2344. In such an example, a computing device may receive input via an input mechanism where the input is associated with the horizontal spacing between wells control 2340 and may automatically adjust the rendered plan 2310 (e.g., re-render the plan 2310 as an adjusted plan). In such an example, a user may optionally select a pad and/or select a grid or grids. As an example, the GUI 2300 may include one or more graphics that display information pertaining to production (e.g., drainage area, etc.) for at least a portion of the plan 2310.

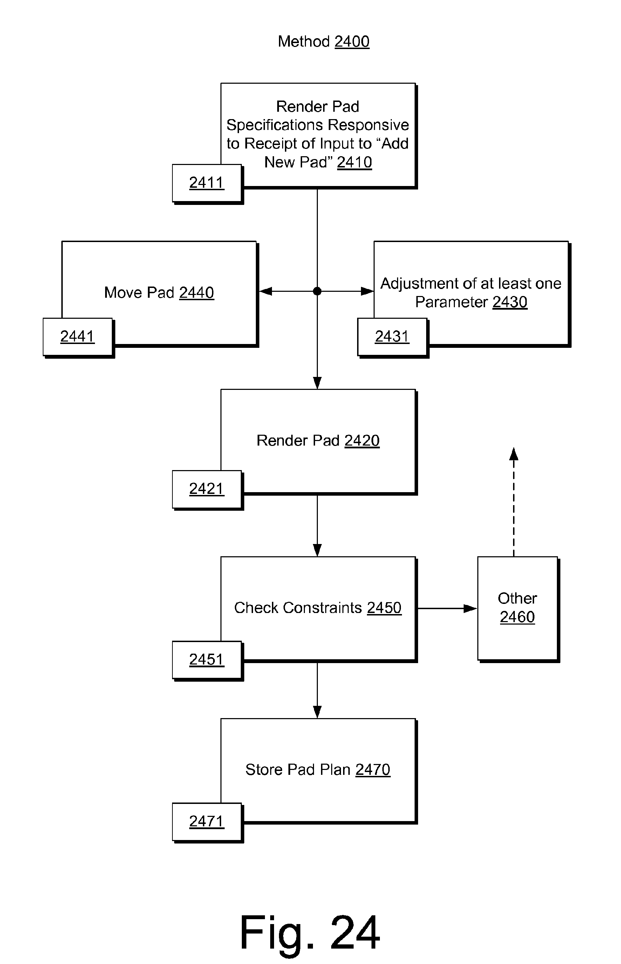

Fig. 24 shows an example of a method 2400 that includes a render block 2410 for rendering pad specifications responsive to receipt of input; a render block 2420 for rendering a pad; an adjustment block 2430 for adjusting at least one parameter value; a movement block 2440 for moving a pad (e.g., drag and drop, etc.); a check block 2450 for checking at least one constraint; an other action block 2460 for taking one or more other actions based at least in part on output of the check block 2450; and a storage block 2470 for storing a pad plan. In the method 2400, the render block 2420 can be implemented automatically for rendering a pad responsive to adjusting at least one parameter value per the adjustment block 2430.

As an example, a graphic of a pad may be rendered to a staging area of a graphical user interface, for example, before being moved into a plan space, which may be represented as a multidimensional graphical user interface optionally with one or more cost surfaces (e.g., one or more visual representations of a constraint or constraints, etc.). In such an example, the render block 2420 may render a pad responsive to receipt of input per the render block 2410.

As an example, where one or more constraints are not met per the check block 2450, the method 2400 may include taking one or more actions per the other block 2460, which may include, for example, proceeding to the move block 2440, proceeding to the adjustment block 2430, etc. (e.g., to help ensure one or more constraints are met).

The method 2400 is shown in Fig. 24 in association with various computer-readable media (CRM) blocks 2411, 2421, 2431, 2441, 2451, 2461 and 2471. Such blocks generally include instructions suitable for execution by one or more processors (or cores) to instruct a computing device or system to perform one or more actions. While various blocks are shown, a single medium may be configured with instructions to allow for, at least in part, performance of various actions of the method 2400. As an example, a computer-readable medium (CRM) may be a computer-readable storage medium that is non-transitory and not a carrier wave. One or more CRM blocks may be provided for graphical user interfaces (GUIs), etc.

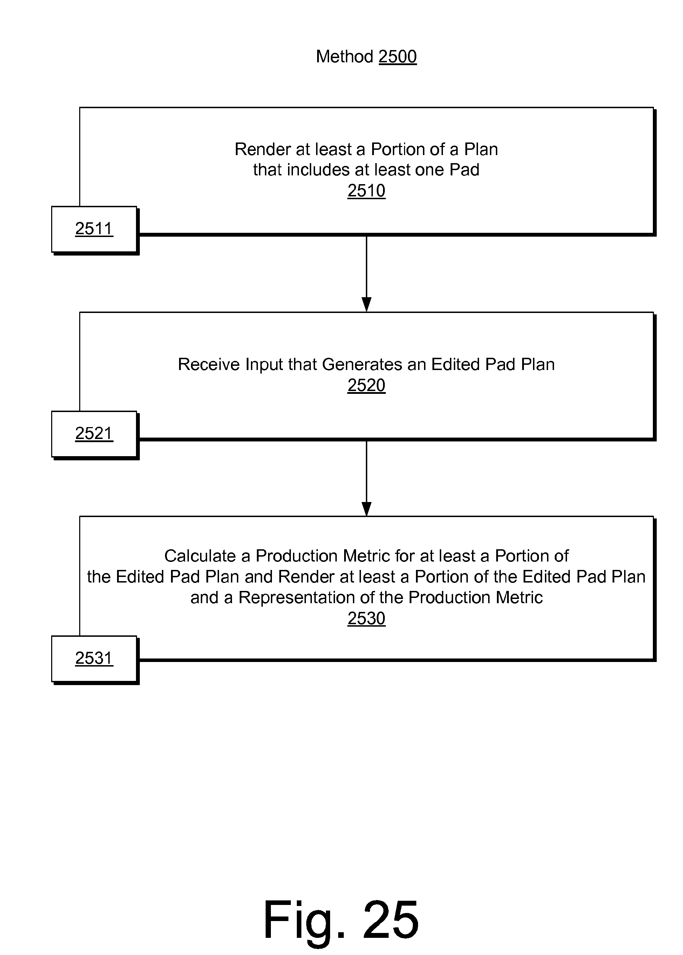

Fig. 25 shows an example of a method 2500 that includes a render block 2510 for rendering at least a portion of a plan that includes at least one pad; a reception block 2520 for receiving input and editing the pad plan responsive to the received input to provide an edited pad plan; and a calculation block 2530 for calculating a production metric for at least a portion of the edited pad plan and rendering at least a portion of the edited pad plan and a representation of the production metric. In such an example, the calculation block 2530 may be contingent on a checking process. For example, if received input as to a proposed edit causes one or more constraints to be violated according to a checking process, the method 2500 may include issuing a notification that the proposed edit is prohibited and, for example, stating a reason why the proposed edit is prohibited.

As an example, a production metric may be or be based at least in part on a drainage area. As mentioned, drainage area may be defined as a boundary of points representing heels and toes of wells associated with a pad, for example, plus one or more bounding distances (e.g., consider a bounding or border distance Bx in an x-direction and a bounding or border distance By in a y-direction). As an example, the calculation block 2530 of the method 2500 can include calculating such a drainage area as the production metric or, for example, calculating such a drainage area and using the calculated drainage area to calculate a production metric.

As an example, a drainage area may be specified numerically by dimensions. For example, consider a drainage area specified by distances in an x-direction and a y-direction. As another example, consider a drainage area specified by a radius or a diameter. As an example, a drainage area may be represented visually, for example, as a boundary that encloses an area. As an example, a drainage area may be represented visually as a rectangle. As an example, a drainage area may be represented visually as a circle or other type of curved boundary. As an example, a drainage area may be represented visually as a combination of one or more lines and one or more curves.

The method 2500 is shown in Fig. 25 in association with various computer-readable media (CRM) blocks 2511, 2521 and 2531. Such blocks generally include instructions suitable for execution by one or more processors (or cores) to instruct a computing device or system to perform one or more actions. While various blocks are shown, a single medium may be configured with instructions to allow for, at least in part, performance of various actions of the method 2500. As an example, a computer-readable medium (CRM) may be a computer-readable storage medium that is non-transitory and not a carrier wave. One or more CRM blocks may be provided for graphical user interfaces (GUIs), etc.

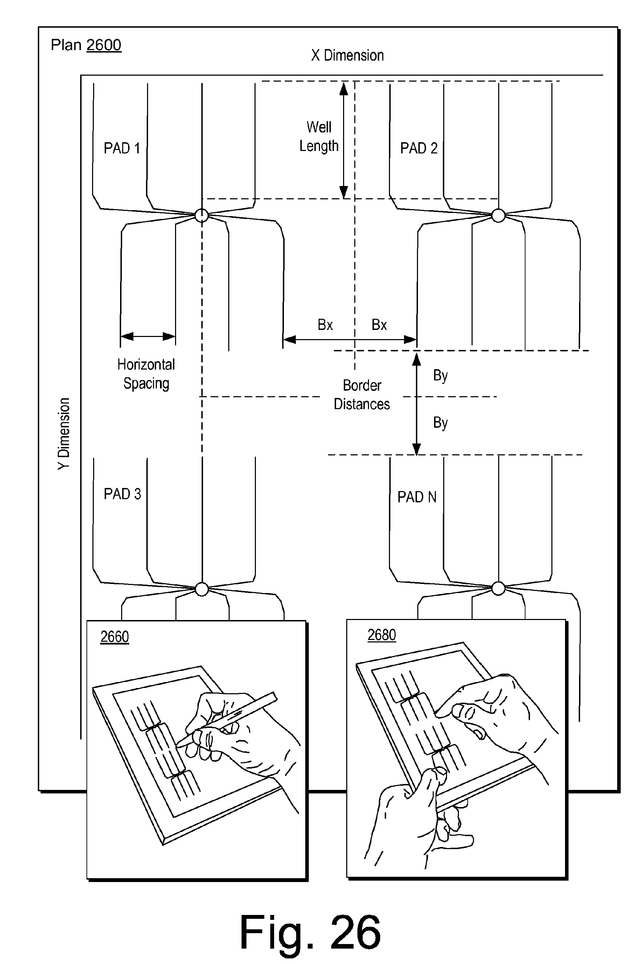

Fig. 26 illustrates an example of a portion of a plan 2600 that is defined at least in part with respect to two dimensions (e.g., X and Y), an example of a computing device or system 2600 and an example of a computing device or system 2670. As shown in Fig. 26, the plan 2600 includes pads 1, 2, 3 and N. In such an example, the pads may be defined with respect to various parameter values. For example, consider well length, horizontal spacing and one or more border distances. As an example, such parameters may be set forth in one or more equations that may be germane to one or more production metrics. As an example, drainage area of a pad and its associated wells may be a production metric. Such a production metric may be represented numerically by one or more numbers (e.g., one or more dimensions, an area, etc.) and may be represented graphically, for example, via one or more of a line, lines, shading, hatching, a curve, curves, etc.

As an example, one or more controls may exist to overlay one or more of a cost surface, a constraint, a stress map, etc. to the plan 2600, which may be rendered to a display as a graphical user interface. As an example, where a display is a touch screen display (e.g., and/or digitizer display), a user may directly input via the display using a stylus, a finger, etc. For example, consider touching an end of a well and moving it to shorten the length of the well or, for example, double touching a well to delete it or to delete a pad. In such examples, information rendered to the display may be updated in near real time (e.g., as determined by processing resources, etc. of a computing device, etc.). For example, a touch-based edit may result in re-rendering with lag that is of the order of seconds or less. In such an example, a user may aim to maximize drainage area of a plan by editing the plan, optionally on a pad by pad basis. In such an example, a production metric may be rendered to the display such that a user may comprehend an increase and/or an amount in increase of prospective production via the edited plan. In such an example, a user may be guided by information rendered to the display that helps the user avoid one or more constraints, which may be represented by one or more cost surfaces.

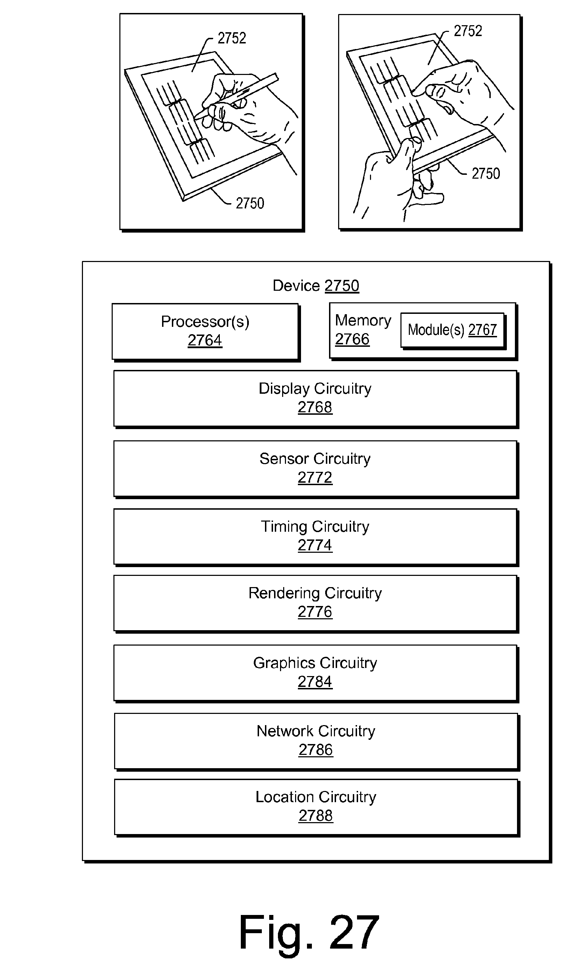

Fig. 27 shows an example of a computing device 2750 that includes a sensor display 2752, which may be a touch screen display that can sense touch and/or stylus input (e.g., via an electromagnetic digitizer panel, etc.). The device 2750 may include one or more processors 2764 (e.g., single or multicore processors, central processors, graphics processors, etc.), memory 2766 that can store one or more modules 2767 (e.g., as executable instructions, etc.), display circuitry 2768, sensor circuitry 2772, timing circuitry 2774, rendering circuitry 2776, graphics circuitry 2784, network circuitry 2786, location circuitry 2788 and optionally other circuitry. As an example, the computing device 2750 can include one or more network interfaces, for example, as part of the network circuitry 2786. As an example, a network interface may allow for transmission and receipt of information from a network, another device, a system, etc. As an example, one or more of the GUI 1700, the GUI 1710, the GUI 1720 and the GUI 1730 of Fig. 17 may be rendered to the sensor display 2752 of the computing device 2750, which may allow for interactions via touch (e.g., via a finger, a stylus, etc.).

As illustrated in Fig. 27, a computing device may be hand-holdable, for example, having a shape format associated with a tablet or a "pad" (e.g., IPAD®, etc.). In such an example, a user may visit a site and edit a plan while at the site (e.g., in an on-site operational mode). As an example, a computing device may include one or more types of location circuitry (e.g., GPS, etc.). As an example, a user may carry a computing device to a site and instruct the computing device to render at least a portion of a plan to a display of the computing device where a locator is also rendered that represents a location of the user (e.g., a location of the computing device). In such a manner, a user may visually inspect a site, know where he or she is located at the site and edit a plan, optionally based on visual inspection while on site.

As an example, a user may visit a site and mark particular locations, for example, using location circuitry. For example, a user may move to a particular pad, position himself or herself at a well head position, a well heel position, a well toe position according to a perceived correspondence between the plan and a position reading of the location circuitry and then mark the position to register it in memory (e.g., to a storage device, etc.). Such fiducials (e.g., GPS coordinates, etc.) may be later used, for example, to edit the plan, to introduce a constraint, to revise a constraint, to alter a cost surface, etc.

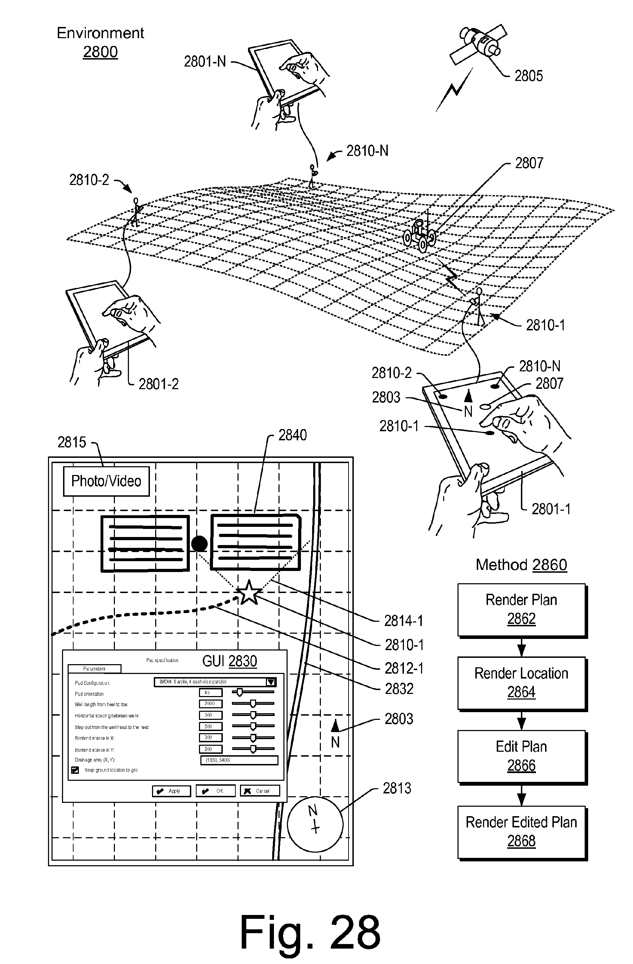

Fig. 28 shows an example of an environment 2800 that includes a surface where one or more devices 2801-1, 2801-2, ... , 2801-N may be located. In the example of Fig. 28, the device 2801-1 may be carried by an individual 2810-1, the device 2801-2 may be carried by an individual 2810-2 and the device 2810-N may be carried by an individual 2810-N (e.g., or by a vehicle, etc.). In such examples, the individuals 2810-1, 2810-2, 2810-N and/or the devices 2801-1, 2801-2, 2801-N may include location circuitry that allows for assigning coordinates (e.g., GPS coordinates, etc.). As an example, airborne equipment 2805 (e.g., a satellite, satellites, a drone, drones, etc.) may communicate with a device or devices such that one or more locations may be determined (e.g., as to an individual, a device, devices, etc.). As an example, consider a drone with a camera (e.g., visible, infrared, etc.) that can detect a location of one or more individuals. As an example, consider a GPS system that can communicate with location circuitry of a device. As an example, consider a land-based location system that can, for example, triangulate or otherwise determine or detect a location of a device (e.g., consider local transmitters/receivers as in a cellular communication system).

As an example, a device may provide for controlling a robot, which may be one or more of a land, air or water robot. For example, consider a robot 2807 that may include one or more types of circuitry (e.g., camera, sensor, communication, etc.). As an example, a device may include communication circuitry that can control one or more operations of a robot (e.g., location, image acquisition, sensing, etc.). In such an example, the device may include a graphical user interface (GUI) for displaying options for control of a robot, for displaying information acquired via a robot, etc.

As an example, a device such as the device 2801-1 may provide for rendering a plan and rendering locations of one or more devices, one or more individuals, etc. For example, the device 2801-1 is shown as displaying locations associated with individuals 2810-1, 2810-2 and 2810-N as well as optionally one or more other locations (e.g., the robot 2807, etc.).

As an example, the plan may include a direction marker (e.g., a north indicator, a compass rose, etc.). As an example, a device may be positionable to align a dimension of the device substantially along a direction of a direction marker of a plan. For example, where a device includes a rectangular display with a long axis and a short axis one of these axes may be aligned in a particular direction, which may be a direction marker of a plan. As an example, a device may include an option to fix a plan rendered to a display to be displayed in a direction determined, for example, via compass circuitry, location circuitry, etc. In such an example, where a user turns the device (e.g., a display), the plan may remain oriented in a particular direction (e.g., with respect to north, south, east, west, etc.).

As an example, a device may render various types of information to a display of the device. In Fig. 28, the device 2801-1 is shown as including a display where the device 2801-1 can render, for example, at least a portion of a plan, a direction marker of a plan 2803, a location of an individual/device 2810-1, a path travelled by an individual/device 2812-1, a compass 2813 (e.g., as associated with location circuitry, direction circuitry, etc.), a path to be travelled by an individual/device 2814-1 (e.g., a recommended path, a planned path, etc.), a graphical control for capturing a photograph and/or for capturing video (e.g., using a camera of the device 2810-1, the robot 2807, the airborne equipment 2805, etc.), one or more GUIs 2830, and one or more features 2832 of the plan (e.g., optionally one or more cost surfaces, constraints, etc.). For example, the feature 2832 may be a railroad track with a right of way (e.g., an easement) as well as bedding material and possibly an access side road. In such an example, the path 2814-1 may be recommended such that a user may inspect a boundary of a planned pad (e.g., a drainage area boundary) to determine whether to edit the planned pad. In such an example, a user may edit the planned pad in real-time (e.g., based at least in part on visual information about a constraint, etc.).

In Fig. 28, the method 2860 includes a render block 2862 for rendering a plan to a display, a render block 2864 for rendering a location of one or more of a device, devices, an individual or individuals to the display, an edit block 2866 for editing at least a portion of the plan and a render block 2868 for rendering at least a portion of the edited plan to the display, for example, in an interactive and automatic manner responsive to editing of at least a portion of the plan.

As an example, where multiple users participate in editing a plan, information may be communicated to devices of the users and/or communicated to a remote device or devices (e.g., remote from the plan location). In such an approach, a system of multiple devices may be used to edit a plan (e.g., in real-time), for example, to increase one or more production metrics over at least a portion of the plan. In such an example, one or more displays may render one or more production metrics in an interactive manner (e.g., automatically) as at least a portion of a plan is being edited.

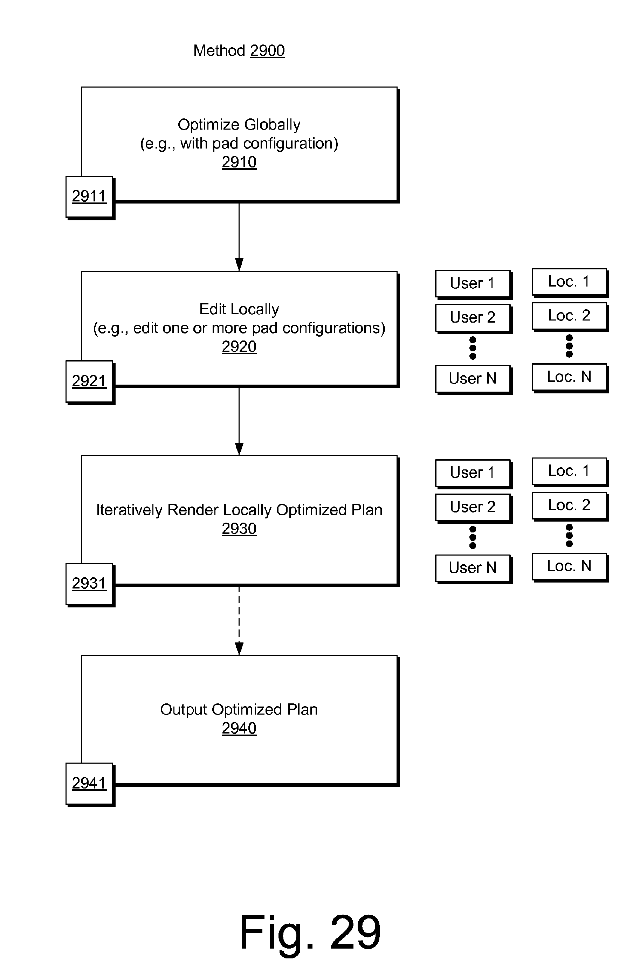

Fig. 29 shows an example of a method 2900 that includes an optimization block 2910 for globally optimizing a plan using, for example, a particular pad configuration such that a globally optimized plan is generated that includes pads that conform to the particular pad configuration; an edit block 2920 for locally editing at least a portion of the plan, for example, to edit at least one instance of a pad by editing its pad configuration such that it differs from the particular pad configuration used in a global optimization; an iteration block 2930 for iteratively rendering one or more locally edited portions of the plan (e.g., as to a locally optimized plan); and an output block 2940 for outputting an optimized plan that is at least in part locally edited. In such an example, a plan that may have been received with uniform pads (e.g., as positioned via a global optimization) may be edited locally to generate an edited plan that includes at least one pad that differs from the uniform pad. As indicated in the example of Fig. 29, editing and/or rendering of the blocks 2920 and 2930 may be via one or more users/devices in, for example, one or more locations.

The method 2900 is shown in Fig. 29 in association with various computer-readable media (CRM) blocks 2911, 2921, 2931 and 2941. Such blocks generally include instructions suitable for execution by one or more processors (or cores) to instruct a computing device or system to perform one or more actions. While various blocks are shown, a single medium may be configured with instructions to allow for, at least in part, performance of various actions of the method 2900. As an example, a computer-readable medium (CRM) may be a computer-readable storage medium that is non-transitory and not a carrier wave. One or more CRM blocks may be provided for graphical user interfaces (GUIs), etc.

As an example, a production metric may be a metric that is germane to production of a resource from a reservoir. As an example, a production metric may be drainage area of a well or wells (e.g., planned, existing, etc.). As an example, a development metric may be a drainage area, for example, a metric that can assist with planning and/or developing field equipment, operations, etc. for production of one or more fluids from a reservoir.

As an example, a plan may be received where pad configurations share a common pad specification. In such an example, a user of a framework may understand that the pads share the common pad specification. In such an example, the user may select a pad and edit its pad specification where at least one production metric is updated in real-time (e.g., computationally in response to receipt of an edit instruction) and rendered to a display such that the user can visually discern the impact of editing on the production metric. As an example, a plan that includes pads with associated pad configurations, which may be according to a common pad specification, may include highlighting as to one or more regions that may be amenable to editing, for example, for one or more reasons (e.g., as to cost, constraints, production, etc.). As an example, a user may edit the plan by editing one or more pads that may be highlighted. In such an example, a user may know a priori which pads are to be edited or examined for editing. In such an example, a list may exist for a user to follow in performing editing of the pads. As an example, where a user edits one pad, a framework may advance automatically to another pad in a list of pads to be edited or examined for editing.

As an example, a method can include rendering at least a portion of a plan to a display of a computing system where the plan includes at least one pad that includes associated wells; receiving input that generates an edited plan; and, responsive to receiving the input, calculating a production metric for at least a portion of the edited plan and rendering at least a portion of the edited plan and a representation of the production metric to the display. In such an example, the production metric can be, can include or can be based at least in part on a drainage area for a pad of the edited plan. As an example, calculating a production metric can include determining at least one heel to toe length of at least one well associated with a pad.

As an example, a representation of a production metric can be or can include a boundary that defines an area (e.g., a drainage area, etc.).

As an example, a method can include checking input (e.g., as to one or more edits) against one or more constraints prior to generation of an edited plan.

As an example, a method can include rendering at least a portion of a plan to a display along with rendering at least one cost surface to the display. In such an example, at least one cost surface may be determined based at least in part on one constraint specified at a ground level or specified at a reservoir level.

As an example, input can include a parameter value that adjusts a dimension of at least one well of a pad. In such an example, a production metric can be, can include or can be based at least in part on a drainage area for the pad (e.g., where the drainage area depends at least in part on the dimension).

As an example, input can include information for a new pad. For example, consider a method that includes adding one or more new pads to a plan.

As an example, input can include information for a pad of a plan, for example, to edit the pad (e.g., edit a pad specification of a pad configuration of the pad, etc.).

As an example, a method can include receiving a plan, editing the plan and generating an edited plan where the edited plan includes a total drainage area that exceeds a total drainage area of the received plan.

As an example, a method can include receiving addition input to edit an edited plan and rendering a graphic to the display that includes a representation of a prior production metric and a representation of a production metric that is calculated at least in part on at least a portion of the additional input.

As an example, a plan can include a pad oriented at an angle and an edited plan can include the pad oriented at a different angle where the different angle acts to minimize or maximize alignment of at least one well associated with the pad with respect to local stress of a stress map.

As an example, a system and/or a device can include a processor; memory operatively coupled to the processor; one or more modules that include processor-executable instructions to instruct the system and/or the device to render at least a portion of a plan to a display where the plan includes at least one pad that includes associated wells; receive input that generates an edited plan; and, responsive to the input, calculate a production metric for at least a portion of the edited plan and render at least a portion of the edited plan and a representation of the production metric to the display. In such an example, the system and/or the device can include the display where, for example, the display is a touch screen display and where, for example, the input includes touch input received via the touch screen display. As an example, a system and/or a device can include location circuitry that outputs a position of the system and/or the device and, for example, instructions to render the position of the system and/or the device to the display.

As an example, one or more computer-readable storage media can include processor-executable instructions to instruct a computing system (e.g., or device) to: render at least a portion of a plan to a display where the plan includes at least one pad that includes associated wells; receive input that generates an edited plan; and, responsive to the input, calculate a production metric for at least a portion of the edited plan and render at least a portion of the edited plan and a representation of the production metric to the display. In such an example, instructions may be included as a plug-in to a framework. As an example, instructions may be included in one or more computer-readable storage media to instruct a computing system to render a graphical user interface to a display.

As an example, a method can include, from a tool palette of a graphical user interface, receiving input to add a new pad; responsive to the input, rendering a pad specification dialog box; receiving input that sets a parameter value (e.g., dragging a slider to the left or to the right, typing a new value, clicking and dragging a pad to a new location, etc.); and responsive to the input, rendering a visualization of the new pad to a display. Such a method may be interactive and perform rendering automatically responsive to input. As an example, such a method may include calculating at least one production metric such as, for example, drainage area associated with wells of a pad. In such an example, rendering of a visualization to a display may include rendering a boundary that represents a calculated drainage area. As an example, a method can include a help option, for example, to render information about one or more procedures, features, etc.

As an example, a method can include rendering a multidimensional graphical user interface that includes at least a portion of a plan. For example, consider a two-dimensional representation of a three-dimensional field to be developed (e.g., further developed, etc.). In such an example, a new pad may be generated and rendered as part of the plan responsive to receipt of input such as a "click", a "touch", etc. at a spot where a user may want to place the new pad. In such an example, input may be received to move the pad (e.g., to click and drag the pad to a different location). As an example, an option may exist to snap a pad or a portion of a pad to a grid (e.g., where it is desired to position the pad on the grid).

As an example, a graphical user interface may be rendered to a display where one or more parameter controls allow for receipt of input to adjust one or more pad specification parameters. In such an example, a visual rendering of a pad or pads to a display may be automatically updated responsive to receipt of the input where, for example, the visual rendering of the pad can include a boundary that represents a drainage area for wells associated with the pad and where the boundary depends on one or more pad specification parameter values (e.g., one or more adjusted values).

As an example, a method can include processing input information to check for a collision or collisions with one or more existing plan features and rendering a pad and one or more associated wells if a collision or collisions do not exist.

As an example, a process can detect and warn about collisions between designed wells and existing wells, and between wells being designed. Such a process may operate via one or more parameters such as, for example, a distance to existing wells parameter. As an example, a process may include making distance calculations for one or more points on a well (e.g., a well associated with a pad being edited, etc.). As an example, a three-dimensional collision detection process may include one or more depth parameters, for example, a minimum measured depth from a well head (e.g., a pad) below which to start collision detection.

As an example, a pad placement workflow may include planning for shale gas producers and oil sand producers. Such a workflow may be applied to environments of interest in North America and other environments as drilling for shale gas expands (e.g., to other continents).

When developing a regional field of shale gas or oil sand reservoirs, operators may consider drilling multiple wells from a well pad location in an effort to maximize a return on investment. As an example, wells drilled at a pad may follow one of a plurality of configurations. For example, a well head configuration can include a row of 4 producer wells located next to a row of 4 injector wells for SAGD development in an oil sand reservoir. As an example, an operator may choose well pad locations based on a combination of constraints at a ground level, such as roads, rivers, buildings, etc., and constraints at a reservoir level, such as lease boundary. A concern of the operators can be selection of pad locations and configurations to achieve more reservoir coverage, which may be characterized based at least in part on drainage area of pads and associated wells. Among alternatives that produce the same reservoir coverage, a secondary concern can be selection of pad locations that incur lower cost. As an example, various approaches may address primary, secondary and optionally one or more other concerns.

As mentioned, a pad placement process may operate in conjunction with a pad well design process, which may be a plug-in for creation of proposed wells on regular configurations (e.g., to be repeated at each pad location), to produce well designs. Applications for such a process can include reservoirs with high well density, such as shale gas or heavy oil. Such a process may seek to control or define well length, vertical and horizontal spacing, orientation, etc.

As an example, a workflow may include receiving information as to a geologic environment that may include features that can be represented by a cost model, for example, one or more features may be represented via one or more equations (e.g., constraint equations). As an example, such a workflow may include rendering cost surfaces to a graphical user interface and one or more tools (e.g., graphical controls) that allow for input to add, edit, delete, etc. one or more pads and associated wells. As an example, an operator may perform a workflow that aims to select and/or revise pad locations. As an example, such a workflow may be performed via a plug-in of a framework such as the PETREL® framework. As an example, a workflow may be applied in brown field development planning.

As an example, a workflow may include creating, revising, etc., a pad placement plan interactively and graphically inside a 2D / 3D window rendered to a display, for example, in an effort to maximize drainage area. In such an example, the workflow can include one or more of adding a new pad location, moving an existing pad to a new location, changing one or more design parameters of an existing pad and as deleting an existing pad. As an example, a well(s) pads can conform to constraints at a ground level (e.g., roads, surface gradients, etc.) and at a reservoir level (e.g., lease boundaries, etc.).

As an example, a workflow can include receiving information as to factors that can be considered during a planning process, such as access to existing roads, avoidance of buildings, etc. In such an example, a framework may include a module or set of modules for a shale play where such information may be converted to constraints at a ground level and at a reservoir level, which, in turn, may be represented visually as one or more cost surfaces that combine effects of various constraints.

As an example, a framework, optionally including one or more plug-ins, etc., may allow a user to create pad configurations that to be replicated, determined to be cost effective and/or that aim to maximize reservoir coverage. As an example, a pad configuration can specifies how many wells are included in a pad and can include layouts of wells associated with a pad. As an example, a pad configuration may contain parameters that can be interactively controlled/adjusted during one or more pad placement procedures that may be for one or more individual pads. As an example, consider one or more parameters such as orientation of a pad, lateral length of wells, horizontal spacing between wells, etc.

As an example, a workflow may include displaying one or more cost surfaces in a graphical user interface rendered to a display, which may be a two-dimensional representation or a three-dimensional representation of a geologic environment. As an example, in addition to the one or more cost surfaces, a user interface may allow for display of one or more selective constraints, such as, for example, one or more of topographic maps, roads, existing wells, etc. Such information, displayed visually, may help a user to visualize various constraints that can be considered during a planning process, a revision process, etc.

As an example, a workflow can include generating a pad placement template that can capture various planning constraints at a ground level and at a reservoir level and can include computing one or more cost surfaces and optionally include generating a pad placement plan. As an example, a pad placement plan may include a set of points or slot object representing pad locations, a set of polygons representing well laterals along with surface attributes indicating a drainage area of an individual pad. In such an example, the points may be generated at least in part via a framework such as, for example, the PETREL® framework. Such points may be specified via coordinates of a coordinate system, which may be a three-dimensional coordinate system that corresponds to a geologic environment.

As an example, a workflow can include receiving information for one or more cost surfaces and displaying at least one of the one or more cost surfaces, for example, in a 2D window or a 3D window rendered to a display. Such a workflow may include receiving information as to an existing pad placement plan and rendering a visual representation of at least a portion of the existing pad placement plan to the 2D window or 3D window. A workflow may then include, for example, a user interacting with one or more input mechanisms of a computing system such that the computing system receives input to activate one of a plurality of operational modes, for example, consider an "add a new pad to the plan" mode, an "edit an existing pad" mode and a "delete an existing pad" mode. One or more operational modes may allow a user to visually create a new pad placement plan or modify an existing plan through interactions with a computing system that renders one or more graphical user interfaces to a display. As an example, interactions may be processed by the computing system such that adjustments to a plan comport with constraints defined at a plurality of levels (e.g., at least in part at a ground level and at a reservoir level) of a geologic environment.

As an example, a method can include adjusting (e.g., systematically) one or more parameters values (e.g., constraints, pad configuration, etc.) to determine how sensitive one or more results (e.g., simulation output) is with respect to the one or more parameters. For example, such a sensitivity analysis may look for economic sensitivity, production sensitivity, etc., to a single parameter or to multiple parameters. As an example, a method can include adjusting one or more parameter values (e.g., for constraints, pad configurations, etc.) by an optimizer to maximize a value such as production from wells proposed to be drilled from one or more pads.

As an example, a pad placement module can provide for user input, for example, to allow a user to experiment with different pad configuration parameters, such as well length or others and to determine the best parameter to be used for the field development.

As an example, a method can include adjusting at least one of a constraint value, a pad configuration definition value, or a constraint value and a pad configuration definition value; and generating pad locations to determine sensitivity of specifications for the generated pad locations to the adjusting of the at least one value. As an example, a method can include providing a function that depends on at least one of a constraint value, a pad configuration definition value, or a constraint value and a pad configuration definition value; and optimizing output of the function by generating pad locations responsive to adjusting at least one of the at least one value of the function.

As an example, a workflow process may optionally be a process associated with the geologic environment 150 of Fig. 1 (e.g., surveying, building, sensing, drilling, injecting, extracting, modeling, simulating, etc.). For example, output from a pad placement process may aid in surveying, building, operating, etc., a pad or related equipment. As an example, consider a workflow that includes communication of information as to pad placement options via a network to equipment located at a site (e.g., computer, cell phone, specialized equipment, etc.). Such information may assist with a survey that acquires additional information and that communicates that additional information to equipment for further optimizing pad placement options. For example, information requesting more detailed survey (e.g., locations of restrictions, soil conditions, etc.) may be communicated and, in response, return data from the more detailed survey to hone placement options.

As an example, a pad placement process or a system for pad placement may, for example, further operate or be configured to control machinery, equipment, or communicate location data to separate devices to influence the operation of those devices in a drilling or pad placement operation. As an example, once a suitable pad placement location is determined, separate devices, such as machinery for drilling, earth moving, etc., may be controlled to construct a pad, place wells via the pad, travel to a pad location, or be otherwise affected in a drilling, pad placement or other associated operation.

As an example, a pad placement product may optionally be suitable to expand capability of the aforementioned PETREL® framework, for example, by offering a solution for regional well planning for shale gas producers and oil sand producers. Such a product may be applied to environments of interest in North America and other environments as drilling for shale gas expands (e.g., to other continents).

When developing a regional field of shale gas or oil sand reservoirs, operators may consider drilling multiple wells from the same well pad location in an effort to maximize a return on investment. As an example, wells drilled at each pad may follow one of several standard configurations. For example, a well head configuration can include a row of 4 producer wells located next to a row of 4 injector wells for SAGD development in an oil sand reservoir. Operators may choose well pad locations based on a combination of constraints at the ground level, such as roads, rivers, buildings, etc., and constraints at the reservoir level, such as lease boundary. A concern of the operators can be selection of pad locations and configurations to achieve more reservoir coverage. Among alternatives that produce the same reservoir coverage, a secondary concern can be selection of pad locations that incur lower cost. As an example, various approaches can optionally address both concerns.

As mentioned, a pad placement process may operate in conjunction with a pad well design process, which may be a plug-in for creation of proposed wells on regular configurations (e.g., to be repeated at each pad location), to produce detailed well designs. Applications for such a process are reservoirs with high well density, such as shale gas or heavy oil. Such a process may seek to control or define well length, vertical and horizontal spacing, orientation, etc.

As an example, a method can include selecting well pad locations and configurations, which conform to constraints both at the ground level, such as roads and surface gradients, and at the reservoir level, such as lease boundaries. A system may be provided to implement such a method where the system allows operators to define their own pad configurations to be used for the field development. In turn, such a system may generate probes from selected pad configurations, and apply the probes to combined constraints to produce well pad locations and pad configurations parameters at each location.

As an example, one or more modules may optionally allow for integration into framework, which, in turn, allows for overall optimization by varying certain parameters, such as well length or pad orientation, in pad configurations. Such an approach can allow a user to experiment with different parameters and determine the best parameters for a development. Such a process may be aided by optimization processes (e.g., automated or semi-automated optimization to reduce manual demands). As an example, a method may include ranking well pad locations, which may help producing pad locations with higher reservoir coverage.

As an example, a method for placing well pads may be implemented, for example, during a regional development planning of a shale gas or oil sand field. In such a method, in addition to the geological and petrophysical characteristics of a reservoir, other factors may be considered during the planning process, such as access to existing roads, avoidance of buildings, etc. Further, as operators often have more than one pad configurations, such a method can include input of various configuration characteristics to define possible pads.

As an example, a pad placement process can provide a way for a user to capture a ground surface and other ground level constraints, for example, using a combination of surfaces, polygons and cost functions. Examples of ground level constraints include, but are not limited to, access to existing roads, avoidance of towns, rivers and cliffs, etc. Such physical constrains may be represented by either polygons or surfaces when such a process is implemented (e.g., optionally in conjunction with the PETREL® framework).

As an example, a pad placement process can utilize one or more cost functions to translate physical constraints such as distances, dips, etc., into normalized costs representing an operators' preference for different physical constraints. A process can optionally allow a user to define one or more cost functions, for example, at different levels of details. For example, along a spectrum, at one end a normalized cost may be either as zero (e.g., null) or not defined, indicating either drillable or non-drillable conditions; whereas, at another end, the normalized cost can be representative to the real cost for drilling under different physical conditions, which enables a method to perform cost optimization in a more realistic way. Such a method may provide a way for a user to capture constraints at the reservoir level using surfaces, polygons and cost functions.

As an example, a system for performing a pad placement process may optionally include a sub-system that combines constraints into, for example, two cost surfaces (e.g., at the ground level and the reservoir level) for representing combined costs. In such an example, for each grid node location of an upper surface, the sub-system calculates a normalized cost at the location for each specified constraint, and assigns the sum of the normalized cost of the individual constraint as the combined cost at the location.

As an example, a system may optionally provide a way for operators to define a set of standard well pad configurations that can be selected by a user. For example, each pad configuration may be made up with one or more well configurations, and a well configuration may be described by coordinates of at least three control points (e.g., well head, heel and toe; see, e.g., Fig. 2). In such an example, coordinates of the control points can be specified using either Cartesian coordinates or cylindrical coordinate system. Arithmetical expressions of numbers and pre-defined variables can then be used to specify the actual coordinates. Such an approach gives a user the option to vary certain parameters, such as well length and pad orientation, for the same pad configuration. Further, given such added flexibility, integration into a framework (e.g., consider the PETREL® framework) can, in turn, allow a user to experiment with different configuration parameters quickly in the search for better field development options.

As an example, a method can include converting a pad configuration into a probe, for example, a 2-dimensional array representing relative positions between a location at a ground level (upper level or surface) and covered reservoir area at a reservoir level (lower level or surface). Given such a probe (or probes), shifting the probe across a two-dimensional ground surface grid can provide for determination of valid ground locations where the corresponding pad configuration of the probe may be placed, at least according to the method constraints. Such a method may optionally include generating a pad allocation plan (e.g., a blueprint), which serves as the basis for additional pad placement options (e.g., optionally in conjunction with features of a framework such as the OCEAN® framework as configured to host the PETREL® framework).

As an example, many variations can exist among different pad placement problems, as each region has its own physical constraints. As an example, a system can optionally provide for different placement options that could produce better placement results under different scenarios. For example, a user may selectively enable additional placement options based on user preference and applicability of a placement option. As an example, one of these options may use a ranking system based on a number of top pad selection that can be placed at each unique grid line, and find line combinations that allow the most number of pads to be place in the region. Such an option can produces a best result, for example, when a user wants to place pads in the same orientation as the grid line.

As an example, a method may optionally provide for analysis with respect to fracturing operations. For example, factors such as orientation of a well with respect to a stress map of natural stress directions may indicate placement locations for pad to drill wells orthogonal to the natural stress directions (e.g., as fracturing may be applied to provide for fractures along natural stress directions).

As an example, a surface or level may be a projection. For example, a reservoir as a three-dimensional structure may be projected to a two-dimensional surface, which may be a lower surface of a model. As an example, other three-dimensional structure may be projected to a two-dimensional surface, which may be an upper surface of a model (e.g., a ground level surface). Such structure may not be at ground level, for example, where infrastructure such as water, sewer, etc., may be buried under ground, it may be within a zone or of such a character (e.g., to be avoided by underground drilling, piping, etc.) that it is projected to an upper surface. Further, for structures that extend above ground, such as elevated power lines, buildings, flight paths for aircraft, these may be projected to an upper surface (e.g., a ground level surface). In general, a constraint may be indicated, assigned or defined by a line, a polygon, a surface, etc., in relationship to one or more model surfaces.

As to objects or other constraints that may impact pad placement or other concerns, such objects may optionally be represented as polygonal or other two-dimensional shapes. For example, for an iceberg with some expected variation in space over time (e.g., lifetime of an operation), the entire expected area may be input as a constraint, optionally with some cost associated if it may deviate or if movement (e.g., by artificial means) is possible at some cost.

As an example, options may be available for new fields and existing fields. For example, a method can include loading locations of existing wells and reevaluation of the wells, optionally for placement of pads for new wells. In such a method, characteristics such as drainage of a reservoir, injection of steam, fracturing, etc., may be accounted for when performing an analysis for placement of one or more new pads for drilling wells.

As an example, a method may include path interference based preliminarily on projections and secondarily on depth to ascertain whether two paths will cross in physical space or otherwise be located in proximity to each other in violation of a constraint or constraints (e.g., regulatory, physical, operational, etc.). A module that includes instructions to perform a path interference analysis may be provided and optionally implemented as an option selected via a graphical user interface. Such an option may allow for input of zones (e.g., depth) with associated constraints or constraints based on type of structure or feature to be avoided (e.g., 20 meters from a steam injection line and 40 meters from a production line). Again, as an example, invocation of such constraints may occur responsive to a projection based analysis for intersecting or closely approaching lines (e.g., at least some of which may be representative of structures or features to be added to an environment).

As an example, various technologies and techniques may apply to situations where surface restrictions on a drilling center, whether drilling is associated with oil, gas, injection, extraction, water, carbon sequestration (e.g., storage), or other operations. Further, output from a method may include information for one or more agencies or regulatory entities. For example, output may be provided to a power utility company to indicate pad placement locations with respect to easements. In other words, the output may be beneficial to multiple parties with property rights, mineral rights, water rights, etc., in an environment.

As an example, one or more modules may be configured for stand-alone implementation using a computing device, system, etc., or configured for bundling with other modules as part of a workflow or workflows. As an example, output of a pad placement method or system may be locations for one or more pads and optionally parameters associated with a selected pad configuration, such as the well length and pad orientation. A system may be configured to render output of pad location(s), for example, via a 3D graphic or a map for visualization, transmit output to a file in a storage device (e.g., optionally as a spreadsheet file).

As an example, output may be consumed directly by one or more other plug-ins (e.g., optionally OCEAN® framework or other), for example, to provide for workflows that may produce hundreds or thousands of projected well paths directly from the various constraints and pad configurations selected for an entire region.

As an example, one or more computer-readable media may include computer-executable instructions to instruct a computing system to output information for controlling a process. For example, such instructions may provide for output to a sensing process, an injection process, a drilling process, an extraction process, etc. Such instructions may be communicated via one or more networks (e.g., cellular, satellite, Internet, etc.).

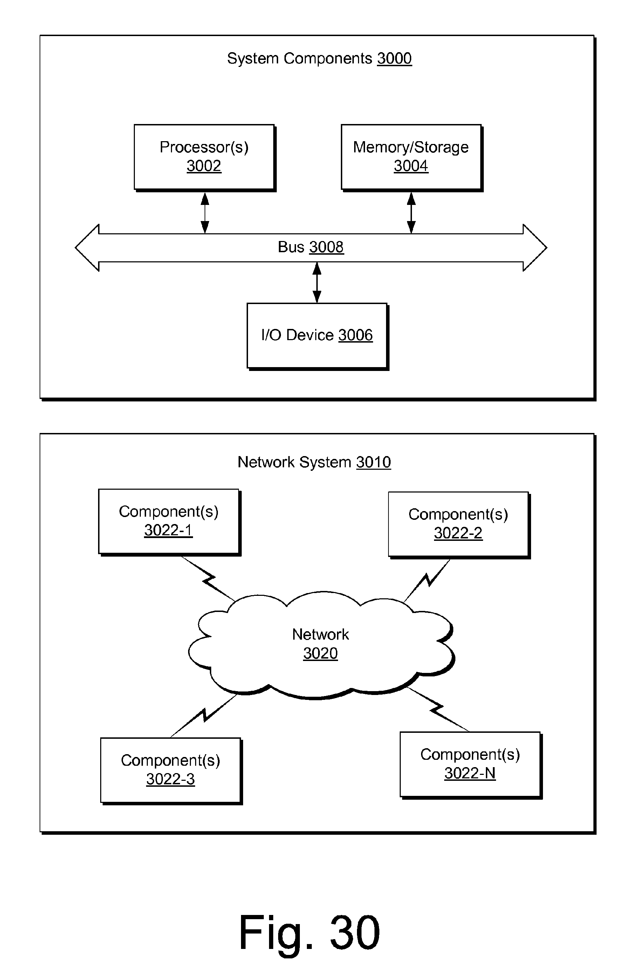

Fig. 30 shows components of a computing system 3000 and a networked system 3010. The system 3000 includes one or more processors 3002, memory and/or storage components 3004, one or more input and/or output devices 3006 and a bus 3008. As an example, instructions may be stored in one or more computer-readable media (e.g., memory/storage components 3004). Such instructions may be read by one or more processors (e.g., the processor(s) 3002) via a communication bus (e.g., the bus 3008), which may be wired or wireless. The one or more processors may execute such instructions to implement (wholly or in part) one or more attributes (e.g., as part of a method). A user may view output from and interact with a process via an I/O device (e.g., the device 3006). As an example, a computer-readable medium may be a storage component such as a physical memory storage device, for example, a chip, a chip on a package, a memory card, etc. (e.g., a computer-readable storage medium).

As an example, components may be distributed, such as in the network system 3010. The network system 3010 includes components 3022-1, 3022-2, 3022-3, ... 3022-N. For example, the components 3022-1 may include the processor(s) 3002 while the component(s) 3022-3 may include memory accessible by the processor(s) 3002. Further, the component(s) 3002-2 may include an I/O device for display and optionally interaction with a method. The network may be or include the Internet, an intranet, a cellular network, a satellite network, etc.

As an example, a device may be a mobile device that includes one or more network interfaces for communication of information. For example, a mobile device may include a wireless network interface (e.g., operable via IEEE 802.11, ETSI GSM, BLUETOOTH®, satellite, etc.). As an example, a mobile device may include components such as a main processor, memory, a display, display graphics circuitry (e.g., optionally including touch and gesture circuitry), a SIM slot, audio/video circuitry, motion processing circuitry (e.g., accelerometer, gyroscope), wireless LAN circuitry, smart card circuitry, transmitter circuitry, GPS circuitry, and a battery. As an example, a mobile device may be configured as a cell phone, a tablet, etc. As an example, a method may be implemented (e.g., wholly or in part) using a mobile device. As an example, a system may include one or more mobile devices.

As an example, a system may be a distributed environment, for example, a so-called "cloud" environment where various devices, components, etc. interact for purposes of data storage, communications, computing, etc. As an example, a device or a system may include one or more components for communication of information via one or more of the Internet (e.g., where communication occurs via one or more Internet protocols), a cellular network, a satellite network, etc. As an example, a method may be implemented in a distributed environment (e.g., wholly or in part as a cloud-based service).

As an example, information may be input from a display (e.g., consider a touchscreen), output to a display or both. As an example, information may be output to a projector, a laser device, a printer, etc. such that the information may be viewed. As an example, information may be output stereographically or holographically. As to a printer, consider a 2D or a 3D printer. As an example, a 3D printer may include one or more substances that can be output to construct a 3D object. For example, data may be provided to a 3D printer to construct a 3D representation of a subterranean formation. As an example, layers may be constructed in 3D (e.g., horizons, etc.), geobodies constructed in 3D, etc. As an example, holes, fractures, etc., may be constructed in 3D (e.g., as positive structures, as negative structures, etc.).

Although only a few example embodiments have been described in detail above, those skilled in the art will readily appreciate that many modifications are possible in the example embodiments. Accordingly, all such modifications are intended to be included within the scope of this disclosure as defined in the following claims. In the claims, means-plus-function clauses are intended to cover the structures described herein as performing the recited function and not only structural equivalents, but also equivalent structures. Thus, although a nail and a screw may not be structural equivalents in that a nail employs a cylindrical surface to secure wooden parts together, whereas a screw employs a helical surface, in the environment of fastening wooden parts, a nail and a screw may be equivalent structures. It is the express intention of the applicant not to invoke 35 U.S.C. § 112, paragraph 6 for any limitations of any of the claims herein, except for those in which the claim expressly uses the words "means for" together with an associated function.

## Claims

1. A method (2500) comprising:
rendering at least a portion of a plan to a display of a computing system wherein the plan comprises at least one pad that comprises associated wells (2510);
receiving input that generates an edited plan (2520); and
responsive to receiving the input, calculating a production metric for at least a portion of the edited plan and rendering at least a portion of the edited plan and a representation of the production metric to the display (2530).

2. The method of claim 1 wherein the production metric comprises a drainage area for a pad of the edited plan.

3. The method of claim 2 wherein the calculating comprises determining at least one heel to toe length of at least one well associated with the pad.

4. The method of claim 1 wherein the representation of the production metric comprises a boundary that defines an area.

5. The method of claim 1 further comprising checking the input against one or more constraints prior to generation of the edited plan.

6. The method of claim 1 wherein the rendering at least a portion of the plan comprises rendering at least one cost surface, and preferably wherein the at least one cost surface is determined based at least in part on one constraint specified at a ground level or specified at a reservoir level.

7. The method of claim 1 wherein the input comprises a parameter value that adjusts a dimension of at least one well of a pad, and preferably wherein the production metric comprises a drainage area for the pad wherein the drainage area depends at least in part on the dimension.

8. The method of claim 1 wherein the input comprises information for a new pad, or information for a pad of the plan.

9. The method of claim 1 wherein the edited plan comprises a total drainage area that exceeds a total drainage area of the plan.

10. The method of claim 1 further comprising receiving addition input to edit the edited plan and rendering a graphic to the display that comprises a representation of the production metric and a representation of a production metric that is calculated at least in part on at least a portion of the additional input.

11. The method of claim 1 wherein the plan comprises a pad oriented at an angle and wherein the edited plan comprises the pad oriented at a different angle wherein the different angle acts to minimize or maximize alignment of at least one well associated with the pad with respect to local stress of a stress map.

12. A device (2750) comprising:
a processor (2764);
memory (2766) operatively coupled to the processor;
one or more modules (2767) that comprise processor-executable instructions to instruct the system to
render at least a portion of a plan to a display wherein the plan comprises at least one pad that comprises associated wells (2511);
receive input that generates an edited plan (2521); and
responsive to the input, calculate a production metric for at least a portion of the edited plan and render at least a portion of the edited plan and a representation of the production metric to the display (2531).

13. The device of claim 12 further comprising the display wherein the display comprises a touch screen display and wherein the input comprises touch input received via the touch screen display.

14. The device of claim 12 further comprising location circuitry that outputs a position of the device wherein the instructions comprise instructions to render the position of the device to the display.

15. One or more computer-readable storage media comprising processor-executable instructions to instruct a computing system to:
render at least a portion of a plan to a display wherein the plan comprises at least one pad that comprises associated wells (2511);
receive input that generates an edited plan (2521); and
responsive to the input, calculate a production metric for at least a portion of the edited plan and render at least a portion of the edited plan and a representation of the production metric to the display (2531).

16. The one or more computer-readable storage media of claim 15 wherein the instructions to instruct a computing system comprise a plug-in to a framework.

17. The one or more computer-readable storage media of claim 15 comprising instructions to instruct a computing system to render a graphical user interface to the display and wherein the input corresponds to one or more graphical controls of the graphical user interface.
